(19) Europäisches Patentamt
European Patent Office
Office européen des brevets

(11) **EP 4 456 402 A1**

(12) **EUROPEAN PATENT APPLICATION**

(43) Date of publication:
**30.10.2024 Bulletin 2024/44**

(51) International Patent Classification (IPC):
**H02M 3/07** (2006.01) **G11C 16/30** (2006.01)

(21) Application number: **24164072.1**

(52) Cooperative Patent Classification (CPC):
**G11C 16/30; H02M 3/071; H02M 3/076; H02M 3/077**

(22) Date of filing: **18.03.2024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.04.2023 CN 202310482966**

(71) Applicant: **Huawei Technologies Co., Ltd.**
**Shenzhen, Guangdong 518129 (CN)**

(72) Inventor: **Zhang, Hao**
**Shenzhen 518129 (CN)**

(74) Representative: **Thun, Clemens**
**Mitscherlich PartmbB**
**Patent- und Rechtsanwälte**
**Karlstraße 7**
**80333 München (DE)**

(54) **CHARGE PUMP CIRCUIT, POWER MANAGEMENT CIRCUIT, AND TERMINAL**

(57) This application relates to the field of circuit technologies, and provides a charge pump circuit, a power management circuit, and a terminal, to prevent a backflow current from being transmitted in the charge pump circuit. The charge pump circuit includes a first auxiliary circuit, a second auxiliary circuit, an input end, an output end, and a first boost circuit and a second boost circuit connected in parallel. The first boost circuit and the second boost circuit are electrically connected between the input end and the output end. When the charge pump circuit is in an operating state, the first boost circuit and the second boost circuit are separately configured to: receive a power supply voltage input by the input end, and boost the power supply voltage. Alternatively, when the charge pump circuit is in a non-operating state, the first boost circuit is further configured to be disconnected under control of a cut-off signal input by the first auxiliary circuit; and the second boost circuit is further configured to be disconnected under control of a cut-off signal input by the second auxiliary circuit.

**Description**

**TECHNICAL FIELD**

This application relates to the field of circuit technologies, and in particular, to a charge pump circuit, a power management circuit, and a terminal.

**BACKGROUND**

Currently, pixel driving in a complementary metal oxide semiconductor image sensor (complementary metal oxide semiconductor image sensor, CIS) may be implemented by a power management circuit including a plurality of charge pump circuits. The power management circuit may select, based on load of each pixel, a quantity of charge pump circuits that need to operate.

However, when some charge pump circuits are in an operating state and some charge pump circuits are in a non-operating state, a floating (floating) voltage in an unstable state is generated inside the charge pump circuit in the non-operating state. A voltage output by the charge pump circuit in the operating state and the floating voltage in the unstable state form a voltage drop. The voltage drop causes the charge pump circuit in the non-operating state to generate a large reverse current (referred to as a backflow current below).

The backflow current is output/input from the charge pump circuit in the non-operating state, and becomes a load current of the charge pump in the operating state. As a result, additional power consumption of the power management circuit increases. In addition, the charge pump circuit in the operating state and the charge pump in the non-operating state form a direct current loop due to the backflow current. When the backflow current flows into the charge pump circuit in the operating state, a voltage drop occurs in the charge pump circuit in the operating state (in other words, a voltage of the backflow current is divided in the charge pump circuit in the operating state), and a headroom (headroom) of a voltage output by the charge pump circuit in the operating state is reduced. This causes poor precision of the voltage output by the charge pump circuit in the operating state and failure of the pixel driving.

**SUMMARY**

To resolve the foregoing technical problem, this application provides a charge pump circuit, a power management circuit, and a terminal, to prevent a backflow current from being transmitted in the charge pump circuit.

According to a first aspect, this application provides a charge pump circuit. The charge pump circuit includes a first auxiliary circuit, a second auxiliary circuit, an input end, an output end, and a first boost circuit and a second boost circuit connected in parallel. The first boost circuit and the second boost circuit are electrically connected between the input end and the output end. When the charge pump circuit is in an operating state, the first boost circuit and the second boost circuit are separately configured to: receive a power supply voltage input by the input end, and boost the power supply voltage. When the charge pump circuit is in a non-operating state, the first boost circuit is further configured to be disconnected under control of a cut-off signal input by the first auxiliary circuit; and the second boost circuit is further configured to be disconnected under control of a cut-off signal input by the second auxiliary circuit.

When the charge pump circuit is in the non-operating state, the first auxiliary circuit inputs the cut-off signal to the first boost circuit, so that the first boost circuit is disconnected; and the second auxiliary circuit inputs the cut-off signal to the second boost circuit, so that the second boost circuit is disconnected. The first boost circuit and the second boost circuit are disposed between the input end and the output end. Therefore, when the first boost circuit and the second boost circuit of the charge pump circuit in the non-operating state are disconnected, if the charge pump circuit is a positive charge pump circuit, a backflow current can be prevented from being input from a positive charge pump circuit in an operating state to a positive charge pump circuit in a non-operating state; if the charge pump circuit is a negative charge pump circuit, a backflow current can be prevented from being input from a negative charge pump circuit in a non-operating state to a negative charge pump circuit in an operating state. In other words, the backflow current cannot be input to the first boost circuit and the second boost circuit of the charge pump circuit in the non-operating state, and cannot be output from the first boost circuit and the second boost circuit of the charge pump circuit in the non-operating state.

Further, because the backflow current is no longer transmitted in the charge pump circuit, the backflow current can be prevented from being a load current of a power management circuit, and power consumption of the power management circuit increases. In addition, because the backflow current cannot be input or output from the charge pump circuit in the non-operating state, the charge pump circuit in the non-operating state and the charge pump in the operating state cannot form a direct current loop. This can prevent a voltage of the backflow current from being divided in the charge pump circuit in the operating state, a headroom of the voltage output by the charge pump circuit in the operating state is reduced, precision of the voltage output by the charge pump circuit in the operating state is affected, and pixel driving fails.

In some possible implementations, the charge pump circuit further includes a first control end and a second control end. The first boost circuit includes a first transistor. A gate of the first transistor is electrically connected to the first control end, a first electrode is electrically connected to the input end, and a second electrode is electrically connected to the output end. The first auxiliary circuit includes a third transistor. A gate of the third transistor is electrically connected to the second control end, a first electrode is electrically connected to the input end, and a second electrode is electrically connected to the gate of the first transistor. When the charge pump circuit is in the non-operating state, the first transistor is cut off under control of the third transistor.

The second boost circuit includes a fourth transistor. A gate of the fourth transistor is electrically connected to the second control end, a first electrode is electrically connected to the input end, and a second electrode is electrically connected to the output end. The second auxiliary circuit includes a sixth transistor. A gate of the sixth transistor is electrically connected to the first control end, a first electrode is electrically connected to the input end, and a second electrode is electrically connected to the gate of the fourth transistor. When the charge pump circuit is in the non-operating state, the fourth transistor is cut off under control of the sixth transistor.

On this basis, the first boost circuit further includes a second transistor and a first capacitor. A gate of the second transistor is electrically connected to the first control end, a first electrode is electrically connected to the second electrode of the first transistor, and a second electrode is electrically connected to the output end. The first capacitor includes a first electrode and a second electrode, the first electrode is electrically connected to the second electrode of the first transistor and the first electrode of the second transistor, and the second electrode is electrically connected to the second control end.

The second boost circuit further includes a fifth transistor and a second capacitor. A gate of the fifth transistor is electrically connected to the second control end, a first electrode is electrically connected to the second electrode of the fourth transistor, and a second electrode is electrically connected to the output end. The second capacitor includes a third electrode and a fourth electrode, the third electrode is electrically connected to the second electrode of the fourth transistor and the first electrode of the fifth transistor, and the fourth electrode is electrically connected to the first control end.

When the charge pump circuit is in the operating state, a voltage at the first control end is a first clock signal, and a voltage at the second control end is a second clock signal. The first clock signal at the first control end is used to control conduction/cut off of the first transistor, the second transistor, and the sixth transistor, and the second clock signal at the second control end is used to control conduction/cut off of the third transistor, the fourth transistor, and the fifth transistor, to implement voltage boosting through the first boost circuit and the second boost circuit respectively.

Alternatively, when the charge pump circuit is in the non-operating state, a voltage at the first control end is a first fixed voltage, and a voltage at the second control end is a second fixed voltage. The voltages at the first control end and the second control end each are fixed voltages. Different from the clock signal, the fixed voltage has no signal fluctuation (in other words, there is no power down). Therefore, voltages at the second electrode of the first capacitor and the fourth electrode of the second capacitor each are a fixed value, and the first electrode of the first capacitor and the third electrode of the second capacitor each are in a floating state. Conduction statuses of the first transistor to the sixth transistor are uncertain. If a first transistor and a second transistor of a same negative charge pump circuit are conducted, and/or a fourth transistor and a fifth transistor of a same negative charge pump circuit are conducted, the foregoing backflow current is input from a negative charge pump circuit in a non-operating state to a negative charge pump in an operating state. If a first transistor and a second transistor of a same positive charge pump circuit are conducted, and/or a fourth transistor and a fifth transistor of a same positive charge pump circuit are conducted, the foregoing backflow current is input from a positive charge pump circuit in an operating state to a positive charge pump in a non-operating state.

For example, the charge pump circuit is a negative charge pump circuit, the input end is electrically connected to a ground end, the first transistor, the third transistor, the fourth transistor, and the sixth transistor each are a P-type transistor, and the second transistor and the fifth transistor each are an N-type transistor. It is assumed that the power supply voltage is boosted through the first boost circuit, the first transistor and the second transistor are conducted, and the fourth transistor and the fifth transistor are cut off.

If the third transistor operates in a cut-off region, a source-gate voltage difference of the third transistor needs to satisfy Formula 4:

$$V_{sg\_M3} = 0 - Vc < V_{thp} \text{ (Formula 4)}.$$

If the fifth transistor operates in the cut-off region, a source-gate voltage difference of the fifth transistor needs to satisfy Formula 5:

$$Vc - Vo < V_{thn} \quad \text{(Formula 5)}.$$

Further, the following is obtained through derivation according to Formula 4 and Formula 5:

$$-V_{thp} < Vc < V_{thn} + V_o \quad \text{(Formula 6)}.$$

$V_{thp} + V_{thn} > -V_o$ may be obtained according to Formula 6.

The negative charge pump circuit requires a power supply of -3.3 V to -2 V for a CIS. In other words, a voltage -VDD output by the negative charge pump circuit usually ranges from -3.3 to -2 V. For example, the negative charge pump circuit requires a power supply of -VDD=-2.8 V for a CIS, or the negative charge pump circuit requires a power supply of -VDD=-3.3 V for a CIS. For example, the negative charge pump circuit requires a power supply of -VDD=-2.8 V for the CIS, and $V_{thp} + V_{thn} > -V_o = 2.8$ V.

However, for a current standard CMOS process for preparing the CIS, regardless of whether the CMOS is an N-type transistor or a P-type transistor, neither a threshold voltage of the N-type transistor nor a threshold voltage of the P-type transistor exceeds 1 V. Further, a sum of the threshold voltage of the N-type transistor and the threshold voltage of the P-type transistor cannot exceed 2 V. Therefore, $V_{thp} + V_{thn} > -V_o = 2$ V is not established.

In addition, it is reversely proved that it is not established when the negative charge pump circuit is in the non-operating state, the first transistor is conducted and the third transistor is cut off. It can be learned from the foregoing description that, to cut off the first transistor, the third transistor may be conducted, that is, when the third transistor is conducted, a source and the gate of the first transistor are conducted, and a source-gate voltage difference of the first transistor is 0, so that the first transistor is cut off. In other words, a cut-off signal is input to the gate of the first transistor through the conducted third transistor, so that the first transistor is cut off.

The first transistor is a part of the first boost circuit, and when the first transistor is cut off, the first boost circuit is also disconnected. In this way, the backflow current cannot be input from the negative charge pump circuit in the non-operating state to the negative charge pump circuit in the operating state through the first boost circuit.

Similarly, it is assumed that the power supply voltage is boosted through the second boost circuit. According to the foregoing formula, a conclusion that the fourth transistor is conducted and the sixth transistor is cut off being not established, and a conclusion that the fifth transistor is cut off by using the conducted sixth transistor may also be obtained through derivation. In this way, the second boost circuit is cut off, and the backflow current cannot be input from the negative charge pump circuit in the non-operating state to the negative charge pump circuit in the operating state through the second boost circuit. Details are not described herein again.

In addition to preventing the backflow current from being transmitted in the negative charge pump circuit, the third transistor may further reduce the gate-source voltage difference of the first transistor at a moment when the negative charge pump circuit is just connected. This prevents the gate-source voltage difference of the first transistor from exceeding a withstand voltage limit 3.3 V of the CIS.

In a solution that the third transistor and the sixth transistor are not included, at the moment when the negative charge pump circuit is just connected, the first transistor is conducted, and the gate-source voltage difference of the first transistor is above the standard withstand voltage limit 3.3 V.

However, in the solution of this application, because the source of the third transistor is electrically connected to the ground end through the input end, a drain of the third transistor is electrically connected to the gate of the first transistor. Therefore, at the moment when the negative charge pump circuit is just connected, the third transistor can be instantaneously conducted, receive a voltage at the ground end through the source, and input the voltage at the ground end to the gate of the first transistor, to pull down a voltage at the gate of the first transistor, and reduce the gate-source voltage difference of the first transistor below the standard withstand voltage limit 3.3 V.

Similarly, at the moment when the negative charge pump circuit is just connected, in the solution of this application, the sixth transistor can be instantaneously conducted, receive the voltage at the ground end through the source, and input the voltage at the ground end to the gate of the fourth transistor, to pull down the voltage at the gate of the fourth transistor. This reduces a gate-source voltage difference of the fourth transistor, and enables the gate-source voltage difference of the fourth transistor below the standard withstand voltage limit 3.3 V.

For example, the charge pump circuit is a positive charge pump circuit, the input end is electrically connected to an operating voltage end, the first transistor, the third transistor, the fourth transistor, and the sixth transistor each are an N-type transistor, and the second transistor and the fifth transistor each are a P-type transistor. It is assumed that the power supply voltage is boosted through the first boost circuit, the first transistor and the second transistor are conducted, and the fourth transistor and the fifth transistor are cut off.

If the third transistor operates in a cut-off region, a source-gate voltage difference of the third transistor needs to satisfy Formula 10:

$$V_{gs\_M3} = Vc - \text{VDD} < V_{thn} \quad \text{(Formula 10)}.$$

If the fifth transistor operates in a cut-off region, the fifth transistor needs to satisfy Formula 11:

$$Vo - Vc < V_{thp} \quad \text{(Formula 11)}.$$

Further, the following is obtained through derivation according to Formula 10 and Formula 11:

$$Vo - V_{thp} < Vc < V_{thp} + \text{VDD} \quad \text{(Formula 12)}.$$

$Vo\text{-}VDD < V_{thp} + V_{thn}$ may be obtained according to Formula 12.

However, in the positive charge pump circuit, the voltage Vo output by the first boost circuit is 2DD. Therefore, $Vo\text{-}VDD < V_{thp} + V_{thn}$ may be represented as $VDD < V_{thp} + V_{thn}$.

Further, the positive charge pump circuit requires a power supply of 2 V to 3.3 V for the CIS. For example, the positive charge pump circuit requires a power supply of VDD=2.8 V for the CIS, or the positive charge pump circuit requires a power supply of VDD=3.3 V for the CIS. For example, the positive charge pump circuit requires a power supply of VDD=2.8 V for the CIS, and $V_{thp} + V_{thn} > VDD$=2.8 V.

However, for the current standard CMOS process for preparing the CIS, regardless of whether the CMOS is an N-type transistor or a P-type transistor, neither a threshold voltage of the N-type transistor nor a threshold voltage of the P-type transistor exceeds 1 V. Further, a sum of the threshold voltage of the N-type transistor and the threshold voltage of the P-type transistor cannot exceed 2 V. Therefore, $V_{thp} + V_{thn} > VDD$=2 V is not established.

In addition, it is reversely proved that it is not established when the positive charge pump circuit is in the non-operating state, the first transistor is conducted and the third transistor is cut off. It can be learned from the foregoing description that, to cut off the first transistor, the third transistor may be conducted, that is, when the third transistor is conducted, the source and the gate of the first transistor are conducted, and the source-gate voltage difference of the first transistor is 0, so that the first transistor is cut off. In other words, the cut-off signal is input to the gate of the first transistor through the conducted third transistor, so that the first transistor is cut off.

The first transistor is a part of the first boost circuit, and when the first transistor is cut off, the first boost circuit is also disconnected. In this way, the backflow current cannot be input from the positive charge pump circuit in the operating state to the positive charge pump circuit in the non-operating state through the first boost circuit.

Similarly, it is assumed that the power supply voltage is boosted through the second boost circuit. According to the foregoing formula, a conclusion that the fourth transistor is conducted and the sixth transistor is cut off being not established, and a conclusion that the fifth transistor is cut off by using the conducted sixth transistor may also be obtained through derivation. In this way, the second boost circuit is cut off, and the backflow current cannot be input from the positive charge pump circuit in the operating state to the positive charge pump circuit in the non-operating state through the second boost circuit. Details are not described herein again.

In addition to preventing the backflow current from being transmitted in the positive charge pump circuit, the third transistor may further reduce a source-gate voltage difference of the first transistor at a moment when the positive charge pump circuit is just connected. This prevents the source-gate voltage difference of the first transistor from exceeding the withstand voltage limit 3.3 V of the CIS.

In a solution that the third transistor and the sixth transistor are not included, at the moment when the positive charge pump circuit is just conducted, the first transistor is conducted, and the source-gate voltage difference of the first transistor is above the standard withstand voltage limit 3.3 V.

However, in the solution of this application, because the source of the third transistor is electrically connected to the operating voltage end through the input end, the drain of the third transistor is electrically connected to the gate of the first transistor. Therefore, at the moment when the positive charge pump circuit is just connected, the third transistor can be instantaneously conducted, receive, through the source, a voltage VDD input from the operating voltage end, and input the voltage VDD to the gate of the first transistor, to pull up the voltage at the gate of the first transistor. This reduces the source-gate voltage difference of the first transistor, and enables the source-gate voltage difference of the first transistor below the standard withstand voltage limit 3.3 V.

Similarly, at the moment when the positive charge pump circuit is just connected, in the solution of this application, the sixth transistor can be instantaneously conducted, receive the voltage VDD through the source, and input the voltage VDD to the gate of the fourth transistor, to pull up the voltage at the gate of the fourth transistor. This reduces the source-gate voltage difference of the fourth transistor, and enables the source-gate voltage difference of the fourth transistor below the standard withstand voltage limit 3.3 V.

In some possible implementations, the charge pump circuit is a cross-coupled charge pump circuit. The first control end includes a first sub-control end and a second sub-control end, the second control end includes a third sub-control end and a fourth sub-control end, the charge pump circuit further includes a seventh transistor, an eighth transistor, a third capacitor, and a fourth capacitor, the third capacitor includes a fifth electrode and a sixth electrode, and the fourth capacitor includes a seventh electrode and an eighth electrode.

The first sub-control end is electrically connected to the gate of the first transistor and a gate of the seventh transistor, the second sub-control end is electrically connected to the gate of the second transistor and the gate of the sixth transistor, the third sub-control end is electrically connected to the gate of the third transistor and the gate of the fifth transistor, and the fourth sub-control end is electrically connected to the gate of the fourth transistor and a gate of the eighth transistor.

A first electrode of the seventh transistor is electrically connected to the input end, a second electrode is electrically connected to the gate of the fourth transistor and the gate of the eighth transistor, a first electrode of the eighth transistor is electrically connected to the input end, and a second electrode is electrically connected to the gate of the first transistor and the gate of the seventh transistor.

The fifth electrode is electrically connected to the gate of the first transistor and the gate of the seventh transistor, the sixth electrode is electrically connected to the first sub-control end, the seventh electrode is electrically connected to the gate of the fourth transistor and the gate of the eighth transistor, and the eighth electrode is electrically connected to the fourth sub-control end.

If the charge pump circuit is a negative charge pump circuit, the seventh transistor and the eighth transistor each are a P-type transistor. If the charge pump circuit is a positive charge pump circuit, the seventh transistor and the eighth transistor each are an N-type transistor.

When the charge pump circuit is in the operating state, the seventh transistor may be used to enhance a capability of a first sub-clock signal to drive the gate of the first transistor, and under control of the first sub-clock signal, the voltage at the gate of the first transistor is quickly pulled up or down, so that the first transistor is quickly conducted or off. The eighth transistor may be used to enhance a capability of a fourth sub-clock signal to drive the gate of the fourth transistor, and under control of the fourth sub-clock signal, the voltage at the gate of the fourth transistor is quickly pulled up or down, so that the fourth transistor is quickly conducted or off.

In some possible implementations, when the charge pump circuit is in an operating state, a voltage at the first sub-control end is a first sub-clock signal, a voltage at the second sub-control end is a second sub-clock signal, a voltage at the third sub-control end is a third sub-clock signal, and a voltage at the fourth sub-control end is a fourth sub-clock signal. Alternatively, when the charge pump circuit is in the non-operating state, a voltage at the first sub-control end is a first sub-fixed voltage, a voltage at the second sub-control end is a second sub-fixed voltage, a voltage at the third sub-control end is a third sub-fixed voltage, and a voltage at the fourth sub-control end is a fourth sub-fixed voltage. Optionally, the first sub-fixed voltage, the second sub-fixed voltage, the third sub-fixed voltage, and the fourth sub-fixed voltage are the same.

When the charge pump circuit is in the operating state, the first sub-clock signal at the first sub-control end is used to control conduction/cut off of the first transistor and the seventh transistor, the second sub-clock signal at the second sub-control end is used to control conduction/cut off of the second transistor and the sixth transistor, the third sub-clock signal at the third sub-control end is used to control conduction/cut off of the third transistor and the fifth transistor, and the fourth sub-clock signal at the fourth sub-control end is used to control conduction/cut off of the fourth transistor and the eighth transistor the fourth transistor and the eighth transistor.

When the charge pump circuit is in the non-operating state, for derivation of an operating process of the charge pump circuit, refer to the foregoing descriptions of Formula 4 to Formula 6 or Formula 10 to Formula 12. Details are not described herein again.

According to a second aspect, this application provides a power management circuit. The power management circuit includes a plurality of power management units, and the power management unit includes a plurality of charge pump circuits according to the first aspect. In a same power management unit, a plurality of charge pump circuits each are a positive charge pump circuit, and a plurality of positive charge pump circuits are connected in parallel; or in a same power management unit, a plurality of charge pump circuits each are a negative charge pump circuit, and a plurality of negative charge pump circuits are connected in parallel.

The second aspect and any one of the implementations of the second aspect respectively correspond to the first aspect and any one of the implementations of the first aspect. For technical effect corresponding to the second aspect and any one of the implementations of the second aspect, refer to technical effect corresponding to the first aspect and any one of the implementations of the first aspect. Details are not described herein again.

According to a third aspect, this application provides a terminal. The terminal includes a circuit board and the power management circuit according to the second aspect, and the power management circuit is disposed on the circuit board.

The third aspect and any one of the implementations of the third aspect respectively correspond to the first aspect and any one of the implementations of the first aspect. For technical effect corresponding to the third aspect and any one of the implementations of the third aspect, refer to technical effect corresponding to the first aspect and any one of the implementations of the first aspect. Details are not described herein again.

## BRIEF DESCRIPTION OF DRAWINGS

FIG. 1 is a diagram of a connection relationship between modules in a terminal according to an embodiment of this application;

FIG. 2a is a diagram of a connection relationship between each power management unit in a power management circuit and a pixel according to an embodiment of this application;

FIG. 2b is a diagram of transmission of a backflow current in a negative charge pump circuit according to an embodiment of this application;

FIG. 2c is a diagram of transmission of a backflow current in a positive charge pump circuit according to an embodiment of this application;

FIG. 3 is a diagram of a charge pump circuit according to a conventional technology;

FIG. 4a is a circuit diagram of a negative charge pump circuit in an operating state according to an embodiment of this application;

FIG. 4b is a circuit diagram of a positive charge pump circuit in an operating state according to an embodiment of this application;

FIG. 5a is a circuit diagram of a negative charge pump circuit in a non-operating state according to an embodiment of this application;

FIG. 5b is a circuit diagram of a positive charge pump circuit in a non-operating state according to an embodiment of this application;

FIG. 6 is a timing diagram of the negative charge pump circuit in the operating state shown in FIG. 4a;

FIG. 7 is a diagram of a voltage change at a gate of a first transistor in a negative charge pump circuit according to an embodiment of this application;

FIG. 8a is a circuit diagram of another negative charge pump circuit in an operating state according to an embodiment of this application;

FIG. 8b is a circuit diagram of another negative charge pump circuit in a non-operating state according to an embodiment of this application;

FIG. 8c is a timing diagram of the negative charge pump circuit in the operating state shown in FIG. 8a;

FIG. 9a is a schematic diagram of backflow currents of the negative charge pump circuit shown in FIG. 8a at different temperatures;

FIG. 9b is a schematic diagram of backflow currents of a negative charge pump circuit at different temperatures according to the conventional technology;

FIG. 10 is a timing diagram of the positive charge pump circuit in the operating state shown in FIG. 4b;

FIG. 11a is a circuit diagram of another positive charge pump circuit in an operating state according to an embodiment of this application;

FIG. 11b is a circuit diagram of another positive charge pump circuit in a non-operating state according to an embodiment of this application; and

FIG. 11c is a timing diagram of the positive charge pump circuit in the operating state shown in FIG. 11a.

Reference numerals:

100: power management circuit; 101: power management unit; 11: first boost circuit; 12: second boost circuit; 21: first auxiliary circuit; and 22: second auxiliary circuit.

## DESCRIPTION OF EMBODIMENTS

The following clearly and completely describes technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and so on are intended to distinguish between different objects but do not indicate a particular order of the objects. For example, a first target object, a second target object, and the like are used for distinguishing between different target objects, but are not used for describing a specific order of the target objects.

In embodiments of this application, the word "example", "for example", or the like is used to represent giving an example, an illustration, or a description. Any embodiment or design scheme described as "example" or "for example" in embodiments of this application should not be explained as being more preferred or having more advantages than another embodiment or design scheme. Exactly, use of the term "example", "for example", or the like is intended to present a related concept in a specific manner.

In the description of embodiments of this application, unless otherwise stated, "multiple" means two or more than two. For example, a plurality of processing units are two or more processing units, and a plurality of systems are two or more systems.

An embodiment of this application provides a terminal. The terminal may be a device having a camera function, such as a consumer electronic product, a home electronic product, a vehicle-mounted electronic product, a financial terminal product, or a communication electronic product.

For example, the consumer electronic product is a mobile phone (mobile phone), a tablet computer (tablet computer), a notebook computer, a personal computer (personal computer, PC), a personal digital assistant (personal digital assistant, PDA), or an uncrewed aerial vehicle. For example, the home electronic product is a television or a smart lock. For ease of description, the following uses an example in which the terminal is a mobile phone for description.

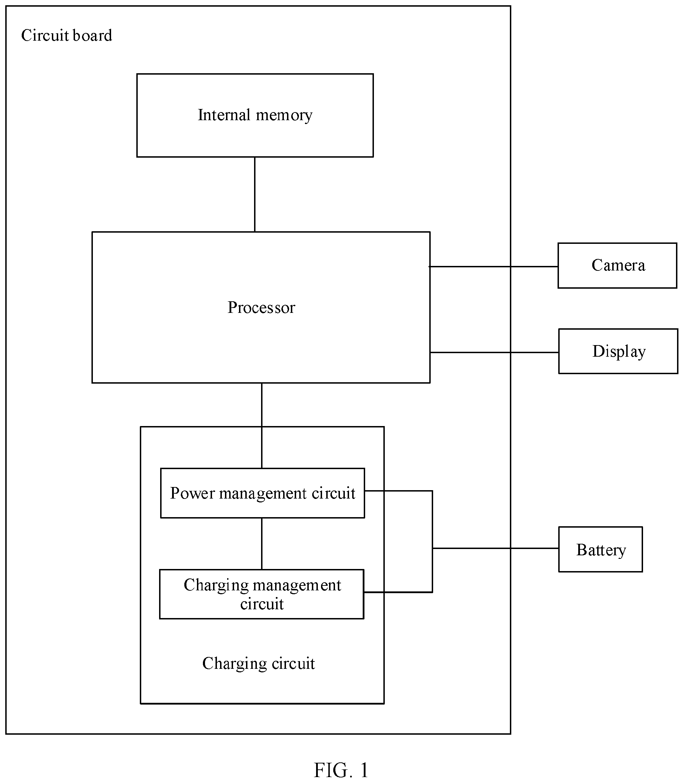

As shown in FIG. 1, the mobile phone may include a circuit board, one or more displays, one or more cameras, and the like. A processor, a memory, a power management circuit (power management integrated circuit, PMIC), and the like may be integrated on the circuit board. Certainly, the mobile phone may further include another component, and another circuit structure may be further integrated into the circuit board. This is not limited in this embodiment of this application.

The processor may include one or more processing units. For example, the processor may include an application processor (application processor, AP), a modem processor, a GPU, an image signal processor (image signal processor, ISP), a controller, a memory, a video codec, a digital signal processor (digital signal processor, DSP), a baseband processor, and/or a neural-network processing unit (neural-network processing unit, NPU). Different processing units may be independent components, or may be integrated into one or more processors.

The GPU is a microprocessor for image processing, and connects the display to the application processor. The GPU is configured to: perform mathematical and geometric computation, and render an image. Therefore, the mobile phone implements a display function by using the GPU, the display, the application processor, and the like.

A display panel may display an image, a video, and the like. The display includes a display panel. The display panel may be a liquid crystal display (liquid crystal display, LCD), an organic light-emitting diode (organic light-emitting diode, OLED), an active-matrix organic light emitting diode (active-matrix organic light emitting diode, AMOLED), a flexible light-emitting diode (flex light-emitting diode, FLED), Miniled, MicroLed, a Micro-oLed, a quantum dot light emitting diode (quantum dot light emitting diodes, QLED), or the like.

A CIS is an optical sensor, including a plurality of pixels (pixel), and may convert an optical signal that is captured by a camera and that carries information such as luminance and color of external light into an electrical signal, convert the electrical signal into a digital signal by using an analog-to-digital converter, and then process and output the digital signal. As a photosensitive component of "optical-to-electrical conversion", the CIS plays an important role in imaging effect. Photosensitive performance, photosensitive area, and quantum efficiency of the CIS directly affect output quality of an image or a video.

Currently, pixel driving in the CIS may be implemented by a power management circuit including a plurality of charge pump circuits. The power management circuit may select, based on load of each pixel, a quantity of charge pump circuits that need to operate to meet a design requirement of low power consumption of the circuit.

Certainly, the power management circuit including the plurality of charge pump circuits may also supply power to another component in the terminal. This is not limited in this embodiment of this application, provided that a power supply requirement of the component is above 2 V in this embodiment of this application. For ease of description, the following uses an example in which the power management circuit including the plurality of charge pump circuits supplies power to the CIS for description.

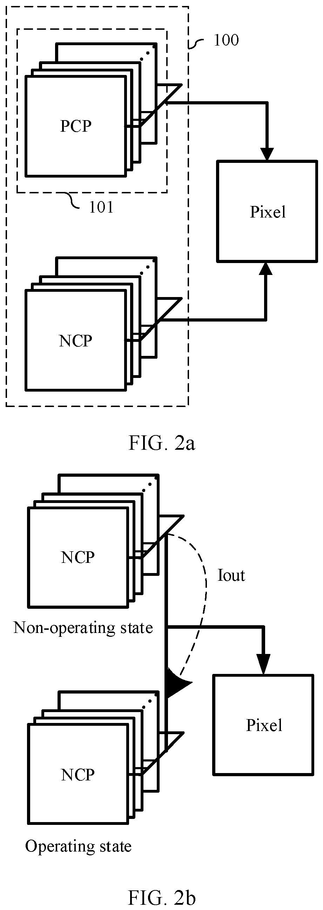

As shown in FIG. 2a, a power management circuit 100 may include a plurality of power management units 101, and the power management unit 101 includes a plurality of charge pump circuits 1011. In a same charge power management unit 101, a plurality of charge pump circuits each are a negative charge pump (negative charge pump, NCP) circuit, and the plurality of negative charge pump circuits are connected in parallel. Alternatively, in a same charge power management unit 101, a plurality of charge pump circuits each are a positive charge pump (positive charge pump, PCP) circuit, and the plurality of positive charge pump circuits are connected in parallel.

However, as mentioned in the background, when some charge pump circuits are in an operating state and some charge pump circuits are in a non-operating state, a floating (floating) voltage in an unstable state is generated inside the charge pump circuit in the non-operating state. A voltage output by the charge pump circuit in the operating state and the floating voltage in the unstable state form a voltage drop. The voltage drop causes the charge pump circuit in the non-operating state to generate a large reverse current (referred to as a backflow current Iout below). The backflow current may be output/input from the charge pump circuit in the non-operating state.

Specifically, as shown in FIG. 2b, for example, the power management circuit 100 includes two power management units 101, and each of the two power management units 101 includes a plurality of negative charge pump circuits connected in parallel. If a plurality of negative charge pump circuits in one power management unit 101 are in an operating state, and a plurality of negative charge pump circuits in the other power management unit 101 are in a non-operating state, a backflow current Iout may be input from the negative charge pump circuit in the non-operating state to the negative charge pump circuit in the operating state.

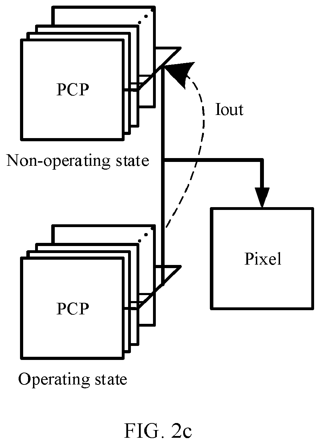

As shown in FIG. 2c, for example, the power management circuit 100 includes two power management units 101, and each of the two power management units 101 includes a plurality of positive charge pump circuits connected in parallel. If a plurality of positive charge pump circuits in one power management unit 101 are in an operating state, and a plurality of positive charge pump circuits in the other power management unit 101 are in a non-operating state, a backflow current Iout may be input from the positive charge pump circuit in the operating state to the positive charge pump circuit in the non-operating state.

The backflow current is output/input from the charge pump circuit in the non-operating state, and becomes a load current of the charge pump in the operating state. As a result, additional power consumption of the power management circuit increases. In addition, the charge pump circuit in the operating state and the charge pump in the non-operating state form a direct current loop due to the backflow current. When the backflow current flows into the charge pump circuit in the operating state, a voltage drop occurs in the charge pump circuit in the operating state (in other words, a voltage of the backflow current is divided in the charge pump circuit in the operating state), and a headroom (headroom) of a voltage output by the charge pump circuit in the operating state is reduced. This causes poor precision of the voltage output by the charge pump circuit in the operating state and failure of the pixel driving

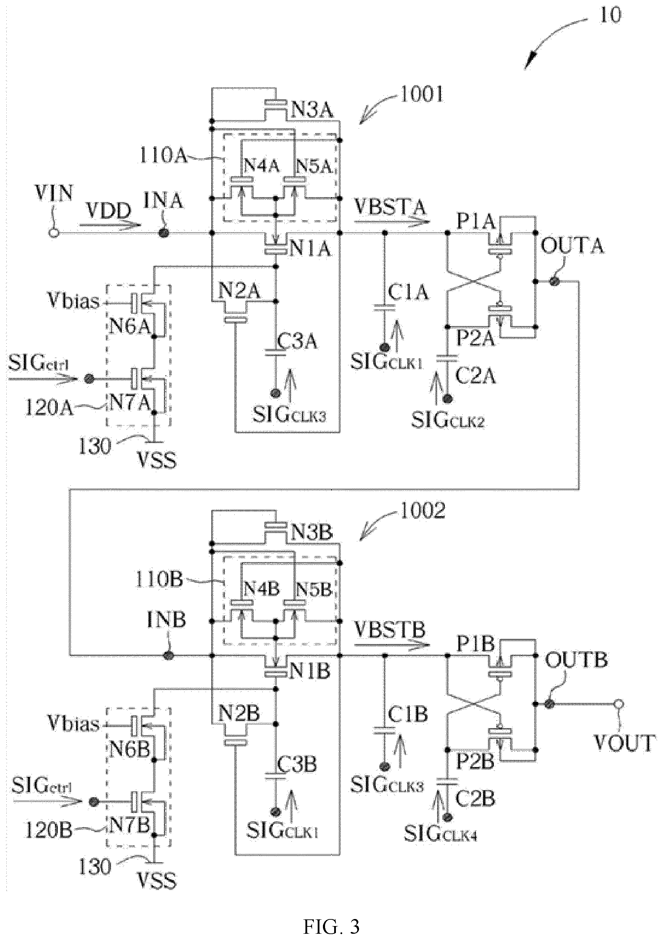

FIG. 3 shows a charge pump circuit according to a conventional technology. A transistor N1A is quickly cut off based on a bootstrap action of a transistor N2A, to prevent a reverse current of a capacitor C3A from being input to the transistor N1A. A transistor N1B is quickly cut off based on a bootstrap action of a transistor N2B, to prevent a reverse current of a capacitor C3B from being input to the transistor N1B.

However, the reverse current caused by charging and discharging of the capacitor (C3A/C3B) inside the single charge pump circuit in this technology is different from the foregoing backflow current Iout occurring between the plurality of power management units 101. In this application, the reverse current generated by the charge pump circuit in the non-operating state due to the voltage in the unstable state needs to be suppressed.

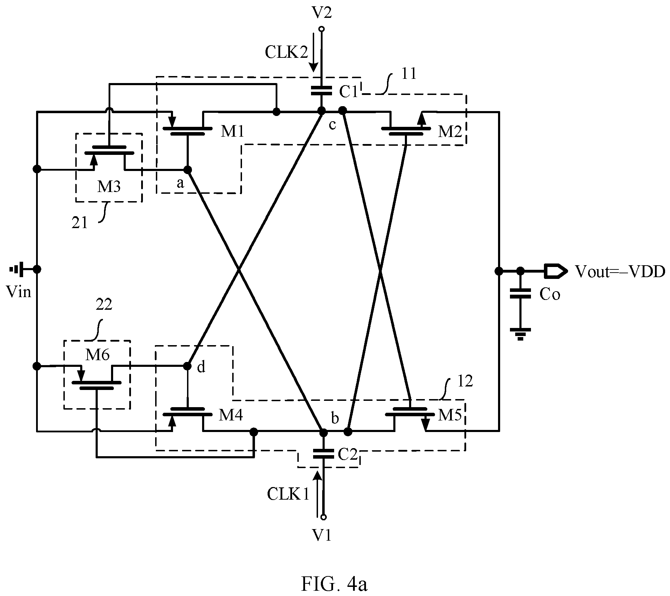

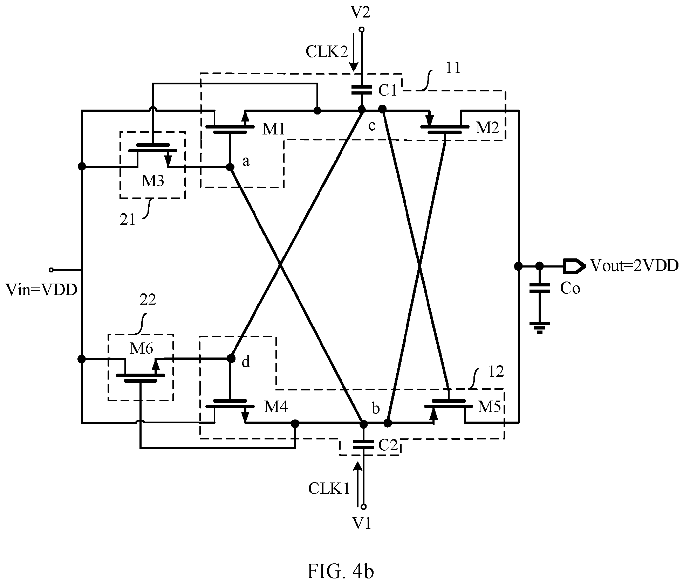

Based on this, an embodiment of this application provides a charge pump circuit. As shown in FIG. 4a and FIG. 4b, the charge pump circuit includes an input end Vin, an output end Vout, a first auxiliary circuit 21, a second auxiliary circuit 22, and a first boost circuit 11 and a second boost circuit 12 connected in parallel. The first boost circuit 11 is electrically connected between the input end Vin and the output end Vout.

As shown in FIG. 4a and FIG. 4b, when the charge pump circuit is in an operating state, the first boost circuit 11 and the second boost circuit 12 are separately configured to receive a power supply voltage input by the input end Vin, and boost the power supply voltage, to obtain a boosted voltage, and output the boosted voltage through the output end Vout, so that the first boost circuit 11 operates normally.

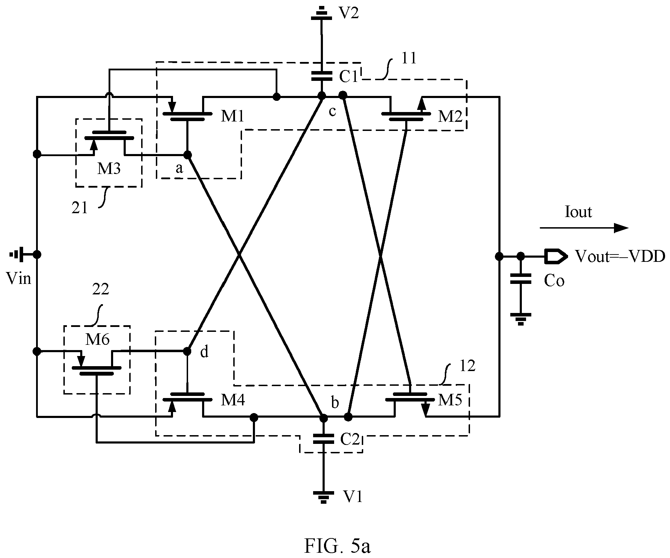

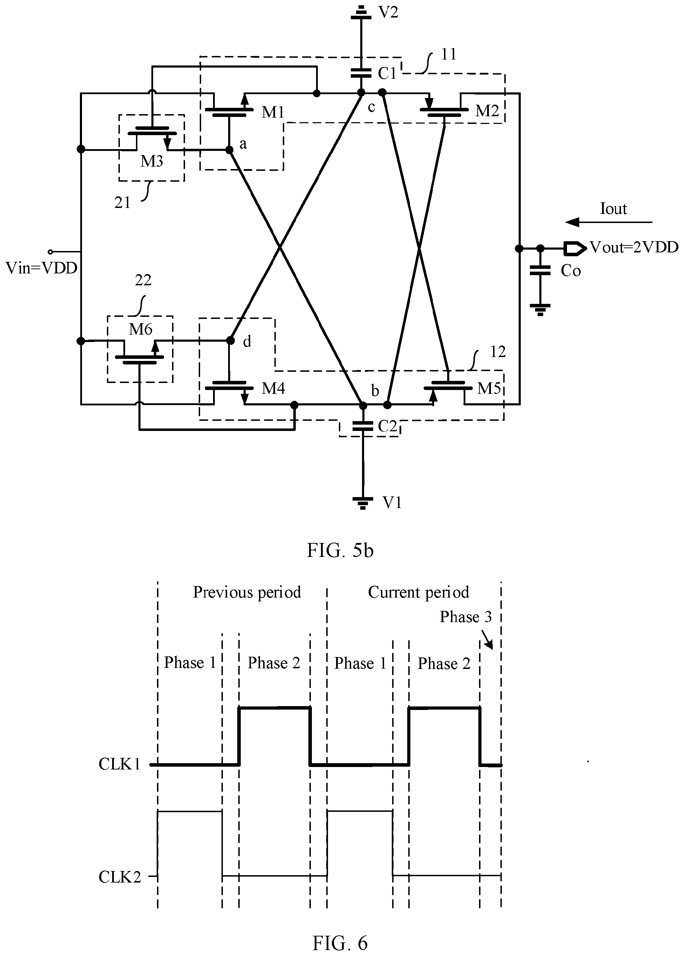

As shown in FIG. 5a and FIG. 5b, when the charge pump circuit is in a non-operating state, the first boost circuit 11 is further configured to be disconnected under control of a cut-off signal input by the first auxiliary circuit 21. The second boost circuit 12 is further configured to be disconnected under control of a cut-off signal input by the second auxiliary circuit 22. In addition, when the charge pump circuit is in the operating state, both the first boost circuit 11 and the second boost circuit 12 of the charge pump circuit can boost the power supply voltage.

On the contrary, when the charge pump circuit is in the non-operating state, neither the first boost circuit 11 nor the second boost circuit 12 of the charge pump circuit boosts the power supply voltage. In addition, the first boost circuit 11 and the second boost circuit 12 no longer receive the power supply voltage input by the input end Vin.

In this application, when the charge pump circuit is in the non-operating state, the first auxiliary circuit 21 inputs the cut-off signal to the first boost circuit 11, so that the first boost circuit 11 is disconnected; and the second auxiliary circuit 22 inputs the cut-off signal to the second boost circuit 12, so that the second boost circuit 12 is disconnected. The first boost circuit 11 and the second boost circuit 12 are disposed between the input end Vin and the output end Vout. Therefore, when the first boost circuit 11 and the second boost circuit 12 of the charge pump circuit in the non-operating state are disconnected, if the charge pump circuit is a positive charge pump circuit, a backflow current Iout can be prevented from being input from a positive charge pump circuit in an operating state to a positive charge pump circuit in a non-operating state; or if the charge pump circuit is a negative charge pump circuit, a backflow current Iout can be prevented from being input from a negative charge pump circuit in a non-operating state to a negative charge pump circuit in an operating state. In other words, the backflow current Iout cannot be input to the first boost circuit 11 and the second boost circuit 12 of the charge pump circuit in the non-operating state, and cannot be output from the first boost circuit 11 and the second boost circuit 12 of the charge pump circuit in the non-operating state.

Further, because the backflow current Iout is no longer transmitted in the charge pump circuit, the backflow current Iout can be prevented from being a load current of a power management circuit, and power consumption of the power management circuit increases. In addition, because the backflow current Iout cannot be input or output from the charge pump circuit in the non-operating state, the charge pump circuit in the non-operating state and the charge pump in the operating state cannot form a direct current loop. This can prevent a voltage of the backflow current Iout from being divided in the charge pump circuit in the operating state, a headroom of the voltage output by the charge pump circuit in the operating state is reduced, precision of the voltage output by the charge pump circuit in the operating state is affected, and pixel driving fails.

In some embodiments, as shown in FIG. 4a, the charge pump circuit further includes a first control end V1 and a second control end V2. The first control end V1 and the second control end V2 may input different signals to the first boost circuit 11, the second boost circuit 12, the first auxiliary circuit 21, and the second auxiliary circuit 22 at different moments, so that the charge pump circuit is in an operating state or a non-operating state.

Specifically, the first boost circuit 11 may include a first transistor M1 and a second transistor M2. A gate of the first transistor M1 is electrically connected to the first control end V1 through a first node a and a second node b, a first electrode of the first transistor M1 is electrically connected to the input end Vin, and a second electrode of the first transistor M1 is electrically connected to a first electrode of the second transistor M2 and the second control end V2 through a third node c. A gate of the second transistor M2 is electrically connected to the first control end V1 through the second node b, and a second electrode of the second transistor M2 is electrically connected to the output end Vout.

The first auxiliary circuit 21 may include a third transistor M3. A gate of the third transistor M3 is electrically connected to the second electrode of the first transistor M1 and the second control end V2 through the third node c, a first electrode of the third transistor M3 is electrically connected to the input end Vin, and a second electrode of the third transistor M3 is electrically connected to the gate of the first transistor M1 through the first node a.

The second boost circuit 12 may include a fourth transistor M4 and a fifth transistor M5, a gate of the fourth transistor M4 is electrically connected to the second control end V2 through a fourth node d and the third node c, a first electrode of the fourth transistor M4 is electrically connected to the input end Vin, and a second electrode of the fourth transistor M4 is electrically connected to a first electrode of the fifth transistor M5 and the first control end V1 through the second node b. A gate of the fifth transistor M5 is electrically connected to the second control end V2 through the third node c, and a second electrode of the fifth transistor M5 is electrically connected to the output end Vout.

The second auxiliary circuit 22 may include a sixth transistor M6. A gate of the sixth transistor M6 is electrically connected to the second control end V2 and the second electrode of the fourth transistor M4 through the second node b, a first electrode of the sixth transistor M6 is electrically connected to the input end Vin, and a second electrode of the sixth transistor M6 is electrically connected to the gate of the fourth transistor M4 through the fourth node d.

In some possible implementations, for the first transistor M1, the second transistor M2, the third transistor M3, the fourth transistor M4, the fifth transistor M5, and the sixth transistor M6, a first electrode is a source of the transistor, and a second electrode is a drain of the transistor; or a first electrode is a drain of the transistor, and a second electrode is a source of the transistor. For ease of description, the following uses the first electrode as the source of the transistor and the second electrode as the drain of the transistor as an example for description.

On this basis, the first boost circuit 11 may further include a first capacitor C1, and the second boost circuit 12 may further include a second capacitor C2. The first capacitor C1 includes a first electrode and a second electrode, and the second capacitor C2 includes a third electrode and a fourth electrode.

The first electrode is electrically connected to a drain of the first transistor M1, a source of the second transistor M2, the gate of the third transistor M3, and the gate of the fifth transistor M5 through the third node c, and the second electrode is electrically connected to the second control end V2. The third electrode is electrically connected to the gate of the second transistor M2, a drain of the fourth transistor M4, a source of the fifth transistor, and the gate of the sixth transistor M6 through the second node b, and the fourth electrode is electrically connected to the first control end V1.

For example, the charge pump circuit is a negative charge pump circuit. The first transistor M1, the third transistor M3, the fourth transistor M4, and the sixth transistor M6 each may be a P-type transistor, the second transistor M2 and the fifth transistor M5 each may be an N-type transistor, and the input end Vin is electrically connected to a ground end. FIG. 6 is an operating timing diagram of a negative charge pump circuit. It can be learned from the timing diagram that the negative charge pump circuit periodically operates, and an operating process of any period is as follows.

As shown in FIG. 4a and FIG. 6, in phase 1, the first transistor M1, the fifth transistor M5, and the sixth transistor M6 are conducted, and the second transistor M2, the third transistor M3, and the fourth transistor M4 are cut off.

Specifically, a first clock signal CLK1 input by the first control end V1 to the gate of the second transistor M2 through the second node b is at a low level (-VDD, VDD is a positive number), and the second transistor M2 is an N-type transistor. Therefore, the second transistor M2 is cut off.

As shown in FIG. 4a and FIG. 6, the first clock signal CLK1 input by the first control end V1 to the gate of the first transistor M1 through the second node b and the first node a is at a low level (-VDD), and the first transistor M1 is a P-type transistor. Therefore, the first transistor M1 is conducted, and the first transistor M1 receives, through the source, the power supply voltage input by the input end Vin. Because the input end Vin is electrically connected to the ground end, a voltage value of the power supply voltage is 0 V, and the first transistor M1 inputs the power supply voltage 0 V to the first capacitor C1, to charge the first capacitor C1.

It should be understood that, in phase 3 of the previous period, a second clock signal CLK2 at the second control end V2 is at a low level (-VDD), and the first capacitor C1 is electrically connected between the second control end V2 and the third node c. Therefore, in the current period, an initial voltage at the first capacitor C1 is -VDD. In phase 1 of the current period, after a voltage 0 V is input to the first capacitor C1 through the first transistor M1, the voltage at the first capacitor C1 is still -VDD.

According to the current formula of the P-type transistor, a conduction condition of the first transistor M1 serving as the P-type transistor is: A source-gate voltage difference Vsg_M1 of the first transistor M1 is above a threshold voltage Vthp of the P-type transistor (the threshold voltage Vthp is a positive number). If the third transistor M3 is conducted, the gate of the first transistor M1 is electrically connected to the source of the first transistor M1 through the third transistor M3, so that a voltage at the source of the first transistor M1 is the same as a voltage at the gate of the first transistor M1, that is, the source-gate voltage difference Vsg_M1 of the first transistor M1 is equal to 0. This does not meet the conduction condition of the first transistor M1 and is contrary to the fact that the first transistor M1 is conducted under control of the first clock signal CLK1 in phase 1. Therefore, in phase 1, the third transistor M3 is cut off.

Based on this, as shown in FIG. 4a and FIG. 6, the second clock signal CLK2 input by the second control end V2 to the gate of the third transistor M3 through the third node c is at a high level (0 V), and the third transistor M3 is a P-type transistor. Therefore, the third transistor M3 is cut off.

When the second control end V2 controls cut-off of the third transistor M3 through the third node c, the second control end V2 further inputs the second clock signal CLK2 to the fifth transistor M5 through the third node c, the second clock signal CLK2 is at a high level (0 V), and the fifth transistor M5 is an N-type transistor. Therefore, the fifth transistor M5 is conducted. The second capacitor C2 discharges to the fifth transistor M5, and outputs a voltage -VDD through the fifth transistor M5 and the output end Vout, to implement voltage boosting. The voltage - VDD discharged by the second capacitor C2 to the fifth transistor M5 is a sum of a voltage 0 V input by the input end Vin to the second capacitor C2 through the fourth transistor M4 in phase 2 of the previous period and a voltage -VDD input to the second capacitor C2 through the first control end V1 in phase 3 of the previous period. The operating processes of phase 2 and phase 3 of the previous period are the same as the operating processes of phase 2 and phase 3 of the current period. For details, refer to the following description of phase 2 and phase 3 of the current period.

The second clock signal CLK2 input by the second control end V2 to the gate of the fourth transistor M4 through the fourth node d is at a high level (0 V), and the fourth transistor M4 is a P-type transistor. Therefore, the fourth transistor M4 is cut off.

The first clock signal CLK1 input by the first control end V1 to the gate of the sixth transistor M6 through the second node b is at a low level (-VDD), and the sixth transistor M6 is a P-type transistor. Therefore, the sixth transistor M6 is cut off. Because the fourth transistor M4 is cut off in phase 1, conduction of the sixth transistor M6 does not affect the fourth transistor M4.

As shown in FIG. 4a and FIG. 6, in phase 2, the second transistor M2, the third transistor M3, and the fourth transistor M4 are conducted, and the first transistor M1, the fifth transistor M5, and the sixth transistor M6 are cut off.

Specifically, the first clock signal CLK1 input by the first control end V1 to the gate of the first transistor M1 is at a high level (0 V), and the first transistor M1 is a P-type transistor. Therefore, the first transistor M1 is cut off.

The second clock signal CLK2 input by the second control end V2 to the gate of the third transistor M3 is at a low level (-VDD), and the third transistor M3 is a P-type transistor. Therefore, the third transistor M3 is conducted. Because the first transistor M1 is cut off in phase 2, conduction of the third transistor M3 does not affect the first transistor M1.

The first clock signal CLK1 input by the first control end V1 to the gate of the second transistor M2 is at a high level (0 V), and the second transistor M2 is an N-type transistor. Therefore, the second transistor M2 is conducted. The first capacitor C1 discharges to the second transistor M2, and outputs a voltage -VDD through the second transistor M2 and the output end Vout, to implement voltage boosting.

The second clock signal CLK2 input by the second control end V2 to the gate of the fourth transistor M4 through the fourth node d is at a low level (-VDD), and the fourth transistor M4 is a P-type transistor. Therefore, the fourth transistor M4 is conducted, and the fourth transistor M4 receives, through the source, the power supply voltage input by the input end Vin. Because the input end Vin is electrically connected to the ground end, a voltage value of the power supply voltage is 0 V, and the fourth transistor M4 inputs the power supply voltage 0 V to the second capacitor C2, to charge the second capacitor C2.

It should be understood that, in phase 3 of the previous period, the first clock signal CLK1 at the first control end V1 is at a low level (-VDD), and the second capacitor C2 is electrically connected between the first control end V1 and the second node b. Therefore, in the current period, an initial voltage at the second capacitor C2 is -VDD. In phase 2 of the current period, after a voltage 0 V is input to the second capacitor C2, the voltage at the second capacitor C2 is still -VDD.

According to the current formula of the P-type transistor, a conduction condition of the fourth transistor M4 serving as the P-type transistor is: A source-gate voltage difference Vsg_M4 of the fourth transistor M4 is above a threshold voltage Vthp of the P-type transistor (the threshold voltage Vthp is a positive number). If the sixth transistor M6 is conducted, the gate of the fourth transistor M4 is electrically connected to the source of the fourth transistor M4 through the sixth transistor M6, so that a voltage at the source of the fourth transistor M4 is the same as a voltage at the gate of the fourth transistor M4, that is, the source-gate voltage difference Vsg_M4 of the fourth transistor M4 is equal to 0. This does not meet the conduction condition of the fourth transistor M4 and is contrary to the fact that the fourth transistor M4 is conducted under control of the fourth clock signal CLK4 in phase 1. Therefore, in phase 2, the sixth transistor M6 is cut off.

Based on this, as shown in FIG. 4a and FIG. 6, the first clock signal CLK1 input by the first control end V1 to the gate of the sixth transistor M6 through the second node b is at a high level (0 V), and the sixth transistor M6 is a P-type transistor. Therefore, the sixth transistor M6 is cut off.

As shown in FIG. 4a and FIG. 6, in phase 3, the second control end V2 is still at a low level (-VDD), and the second control end V2 may continue to charge the first capacitor C1. The first control end V1 is still at a low level (-VDD), and the first control end V1 may continue to charge the second capacitor C2.

An example in which the charge pump circuit is a negative charge pump circuit is still used. As shown in FIG. 5a, when the negative charge pump is in a non-operating state, and the voltage at the second control end V2 is a second fixed voltage. The first fixed voltage may be the same as or different from the second fixed voltage. Optionally, the first fixed voltage is the same as the second fixed voltage. For example, the first control end V1 and the second control end V2 each are electrically connected to the ground end, and the first fixed voltage and the second fixed voltage each are 0 V; or the first control end V1 and the second control end V2 each are electrically connected to an operating voltage end, and the first fixed voltage and the second fixed voltage each are a VDD.

Certainly, the first fixed voltage and the second fixed voltage may alternatively be other values. This is not limited in this embodiment of this application. For ease of description, the following uses an example in which the first control end V1 and the second control end V2 each are electrically connected to the ground end, and the first fixed voltage and the second fixed voltage each are 0 V for description.

As the name implies, the first fixed voltage and the second fixed voltage each are a fixed voltage value. Different from the clock signal, the fixed voltage has no signal fluctuation (in other words, there is no power down). Therefore, when the negative charge pump is in the non-operating state, voltages at the second electrode of the first capacitor C1 and the fourth electrode of the second capacitor C2 each are 0 V, and the first electrode of the first capacitor C1 and the third electrode of the second capacitor C2 each are in a floating (floating) state.

Further, the first electrode of the first capacitor C1 is electrically connected to the gate of the third transistor M3, the gate of the fourth transistor M4, and the gate of the fifth transistor M5 through the third node c, and the third electrode of the second capacitor C2 is electrically connected to the gate of the first transistor M1, the gate of the second transistor M2, and the gate of the sixth transistor M6 through the second node b. Therefore, when the first electrode of the first capacitor C1 and the third electrode of the second capacitor C2 each are in a floating state, conduction statuses of the first transistor M1 to the sixth transistor M6 are uncertain. If a first transistor M1 and a second transistor M2 of a same negative charge pump circuit are conducted, and/or a fourth transistor and a fifth transistor of a same negative charge pump circuit are conducted, the foregoing backflow current is input from a negative charge pump circuit in a non-operating state to a negative charge pump in an operating state.

It is assumed that the power supply voltage is boosted through the first boost circuit 11, the first transistor M1 and the second transistor M2 are conducted, and the third transistor M3 and the fifth transistor M5 are cut off. The first transistor M1 operates in a saturation region, the second transistor M2 operates in a linear region, and the third transistor M3 and the fifth transistor M5 operate in a cut-off region.

If the first transistor M1 is conducted, the source-gate voltage difference Vsg_M1 of the first transistor M1 needs to satisfy Formula 1:

$$V_{sg\_M1} = 0 - \mathrm{Va} > V_{thp} \quad \text{(Formula 1)}.$$

0 indicates that a voltage that is input by the input end Vin and that is received by the source of the first transistor M1 is 0 V, and Va indicates a voltage at the first node a.

Further, if the first transistor M1 operates in the saturation region, a source-drain voltage difference Vsd_M1 of the first transistor M1 needs to satisfy Formula 2:

$$V_{sd\_M1} = 0 - Vc > V_{sg\_M1} - V_{thp} = -Va - V_{thp} \quad \text{(Formula 2)}.$$

Vc indicates a voltage at the third node c.

If the second transistor M2 operates in the linear region, a gate-drain voltage difference Vgd_M2 of the second transistor M2 needs to satisfy Formula 3:

$$V2 - V_o > V_{thn} \quad \text{(Formula 3)}.$$

The drain of the second transistor M2 is electrically connected to the output end Vout, Vo indicates a voltage output by the output end Vout, and Vthn indicates a threshold voltage of the N-type transistor.

If the third transistor M3 operates in the cut-off region, a source-gate voltage difference Vsg_M3 of the third transistor M3 needs to satisfy Formula 4:

$$V_{sg\_M3} = 0 - Vc < V_{thp} \quad \text{(Formula 4)}.$$

If the fifth transistor M5 operates in the cut-off region, a source-gate voltage difference Vsg_M3 of the fifth transistor M5 needs to satisfy Formula 4:

$$Vc - Vo < V_{thn} \quad \text{(Formula 5)}.$$

Further, the following is obtained through derivation according to Formula 4 and Formula 5:

$$-V_{thp} < Vc < V_{thn} + V_o \quad \text{(Formula 6)}.$$

$V_{thp} + V_{thn} > -V_o$ may be obtained according to Formula 6.

The negative charge pump circuit requires a power supply of -3.3 V to -2 V for a CIS. In other words, a voltage -VDD output by the negative charge pump circuit usually ranges from -3.3 V to -2 V. For example, the negative charge pump circuit requires a power supply of -VDD=-2.8 V for a CIS, or the negative charge pump circuit requires a power supply of -VDD=-3.3 V for a CIS. For example, the negative charge pump circuit requires a power supply of -VDD=-2.8 V for the CIS, and $V_{thp} + V_{thn} > -V_o$=2.8 V.

However, for a current standard CMOS process for preparing the CIS, regardless of whether the CMOS is an N-type transistor or a P-type transistor, neither a threshold voltage Vthn of the N-type transistor nor a threshold voltage Vthp of the P-type transistor exceeds 1 V. Further, a sum of the threshold voltage Vthn of the N-type transistor and the threshold voltage Vthp of the P-type transistor cannot exceed 2 V. Therefore, $V_{thp} + V_{thn} > -V_o$=2 V is not established.

In addition, it is reversely proved that it is not established when the negative charge pump circuit is in the non-operating state, the first transistor M1 is conducted and the third transistor M3 is cut off. It can be learned from the foregoing description that, to cut off the first transistor M1, the third transistor M3 may be conducted, that is, when the third transistor M3 is conducted, the source and the gate of the first transistor M1 are conducted, and the source-gate voltage difference Vsg_M1 of the first transistor M1 is 0, so that the first transistor M1 is cut off. In other words, the cut-off signal is input to the gate of the first transistor M1 through the conducted third transistor M3, so that the first transistor M1 is cut off.

The first transistor M1 is used as a part of the first boost circuit 11, and when the first transistor M1 is cut off, the first boost circuit 11 is also disconnected. In this way, the backflow current Iout cannot be input from the negative charge pump circuit in the non-operating state to the negative charge pump circuit in the operating state through the first boost circuit 11.

Similarly, it is assumed that the power supply voltage is boosted through the second boost circuit 12. According to the foregoing formula, a conclusion that the fourth transistor M4 is conducted and the sixth transistor M6 is cut off being not established, and a conclusion that the fifth transistor M5 is cut off by using the conducted sixth transistor M6 may also be obtained through derivation. In this way, the second boost circuit 12 is cut off, and the backflow current Iout cannot be input from the negative charge pump circuit in the non-operating state to the negative charge pump circuit in the operating state through the second boost circuit 12. Details are not described herein again.

In some possible implementations, in this embodiment of this application, voltage switching at the first control end V1 and the second control end V2 may be implemented by using a switch or through a logic circuit, so that the voltage at the first control end V1 is the first clock signal CLK1 or the first fixed voltage, and the voltage at the second control end V2 is the second clock signal CLK2 or the second fixed voltage. For example, the negative charge pump circuit further includes a first switch and a second switch, and the first switch is electrically connected between the first control end V1 and the ground end and a first clock generation circuit.

When the negative charge pump circuit is in an operating state, the first control end V1 is connected to the first clock generation circuit through the first switch, and the first clock generation circuit inputs the first clock signal CLK1 to the first control end V1 through the first switch. When the negative charge pump circuit is in an operating state, the first control end V1 is connected to the ground end through the first switch, and the ground end inputs the first fixed voltage 0 V to the first control end V1 through the first switch.

Similarly, when the negative charge pump circuit is in an operating state, the second control end V2 is connected to a second clock generation circuit through the second switch, and the second clock generation circuit inputs the second clock signal CLK2 to the second control end V2 through the second switch. When the negative charge pump circuit is in an operating state, the second control end V2 is connected to the ground end through the second switch, and the ground end inputs the second fixed voltage 0 V to the second control end V2 through the second switch.

Certainly, voltage switching at the first control end V1 and the second control end V2 may alternatively be implemented through another logic circuit. The logic circuit may be, for example, an AND gate, a NOT gate, or a NAND gate.

In addition to preventing the backflow current Iout from being transmitted in the negative charge pump circuit, the third transistor M3 may further reduce the gate-source voltage difference Vgs_M1 of the first transistor M1 at a moment when the negative charge pump circuit is just connected. This prevents the gate-source voltage difference Vgs_M1 of the first transistor M1 from exceeding a withstand voltage limit 3.3 V of the CIS.

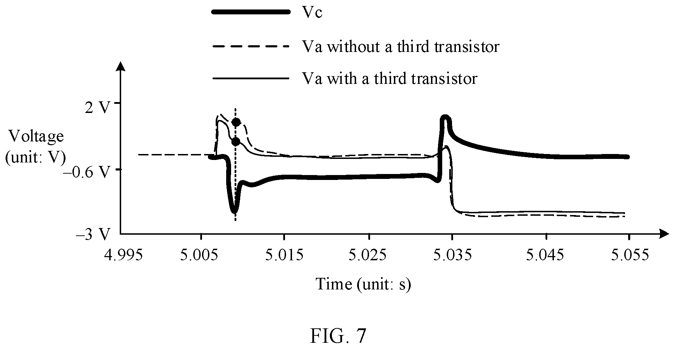

As shown in FIG. 7, in a solution that the third transistor M3 and the sixth transistor M6 are not included, at the moment when the negative charge pump circuit is just connected, the first transistor M1 is conducted, and a voltage Va at the gate of the first transistor M1 is about 1.45 V. Because the voltage Vc at the source of the first transistor M1 is about -2.4 V, the gate-source voltage difference of the first transistor M1 is that Vgs_M1=1.45-(-2.4)=3.85 V, and is above the standard withstand voltage limit 3.3 V.

However, in the solution in this embodiment of this application, because the source of the third transistor M3 is electrically connected to the ground end through the input end Vin, a drain of the third transistor M3 is electrically connected to the gate of the first transistor M1. Therefore, as shown in FIG. 7, at the moment when the negative charge pump circuit is just connected, the third transistor M3 can be instantaneously conducted, receive a voltage at the ground end through the source, and input the voltage at the ground end to the gate of the first transistor M1, to pull down the voltage at the gate of the first transistor M1. This reduces a gate-source voltage difference Vgs_M1 of the first transistor M1, and pulls down the voltage Va at the gate of the first transistor M1 to about 0.6 V. Because the voltage Vc at the source of the first transistor M1 is about -2.4 V, the gate-source voltage difference of the first transistor M1 is that Vgs_M1=0.6-(-2.4)=3 V, and is below the standard withstand voltage limit 3.3 V.

Similarly, at the moment when the negative charge pump circuit is just connected, in the solution of embodiments of this application, the sixth transistor M6 can be instantaneously conducted, receive the voltage at the ground end through the source, and input the voltage at the ground end to the gate of the fourth transistor M4, to pull down the voltage at the gate of the fourth transistor M4. This reduces a gate-source voltage difference Vgs_M4 of the fourth transistor M4, and enables the gate-source voltage difference Vgs_M4 of the fourth transistor M4 below the standard withstand voltage limit 3.3 V.

**Table 1**

|  | Minimum value Min | Maximum value Max |
|---|---|---|
| Vgs_M1 | 3.186 V | 3.762 V |
| Vgs_M4 | 3.163 V | 3.647 V |

**Table 2**

|  | Minimum value Min | Maximum value Max |
|---|---|---|
| Vgs_M1 | 2.722 V | 3.084 V |
| Vgs_M4 | 2.868 V | 3.3 V |

Table 1 and Table 2 are obtained through experiments. Table 1 shows that in the solution that the third transistor M3 and the sixth transistor M6 are not included, the minimum value of the gate-source voltage difference Vgs_M1 of the first transistor M1 is 3.186 V, and the maximum value is 3.762 V. The maximum value exceeds the standard withstand voltage limit 3.3 V. Table 4 shows that in the solution in this embodiment of this application, the minimum value of the gate-source voltage difference Vgs_M1 of the first transistor M1 is 2.722 V, and the maximum value is 3.084 V. Both the minimum value and the maximum value do not exceed the standard withstand voltage limit 3.3 V.

Table 1 further shows that in the solution that the third transistor M3 and the sixth transistor M6 are not included, the minimum value of the gate-source voltage difference Vgs_M4 of the fourth transistor M4 is 3.163 V, and the maximum value is 3.647 V. The maximum value exceeds the standard withstand voltage limit 3.3 V. Table 2 shows that in the solution in this embodiment of this application, the minimum value of the gate-source voltage difference Vgs_M4 of the fourth transistor M4 is 2.868 V, and the maximum value is 3.3 V. Both the minimum value and the maximum value do not exceed the standard withstand voltage limit 3.3 V.

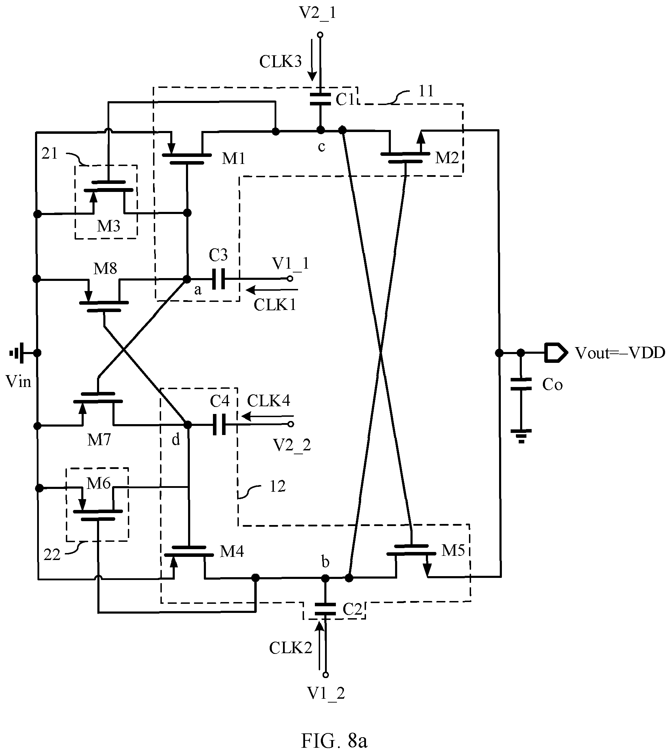

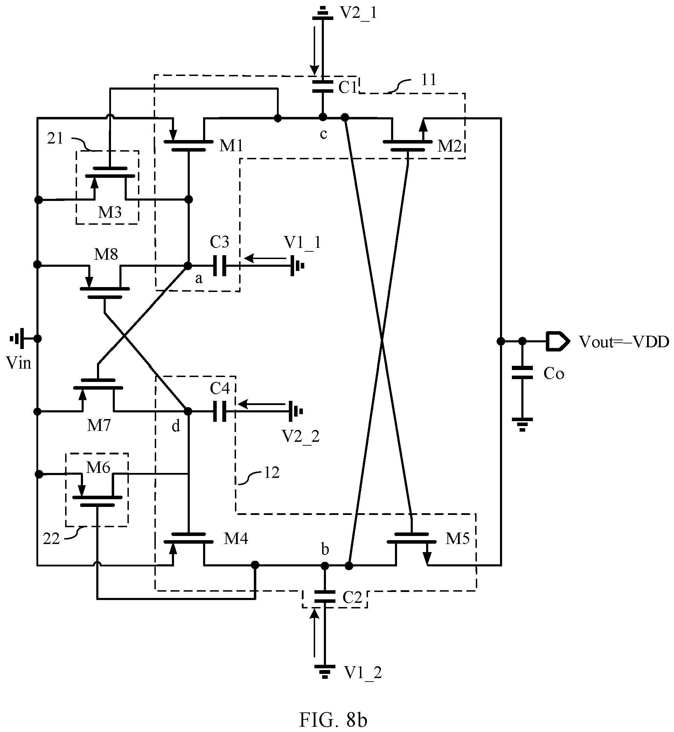

In some embodiments, as shown in FIG. 8a and FIG. 8b, the negative charge pump is a cross-coupled (cross couple) negative charge pump circuit, and the negative charge pump circuit may further include a seventh transistor M7 and an eighth transistor M8. The first control end V1 includes a first sub-control end V1_1 and a second sub-control end V1_2, and the second control end V2 includes a third sub-control end V2_1 and a fourth sub-control end V2_2.

The first sub-control end V1_1 is electrically connected to the gate of the first transistor M1 through the first node a, to input, in the operating state, the first sub-clock signal CLK1_1 to the gate of the first transistor M1. The second sub-control end V1_2 is electrically connected to the gate of the second transistor M2 and the gate of the sixth transistor M6 through the second node b, to input, in the operating state, the second sub-clock signal CLK1_2 to the gate of the second transistor M2 and the gate of the sixth transistor M6. The third sub-control end V2_1 is electrically connected to the gate of the third transistor M3 and the gate of the fifth transistor M5 through the third node c, to input, in the operating state, the third sub-clock signal CLK2_1 to the gate of the third transistor M3 and the gate of the fifth transistor M5. The fourth sub-control end V2_2 is electrically connected to the gate of the fourth transistor M4 through the fourth node d, to input, in the operating state, the fourth sub-clock signal CLK2_2 to the gate of the fourth transistor M4.

A gate of the seventh transistor M7 is electrically connected to the first sub-control end V1_1 and the gate of the first transistor M1 through the first node a, a source of the seventh transistor M7 is electrically connected to the input end Vin1, and a drain of the seventh transistor M7 is electrically connected to the fourth sub-control end V2_2 through the fourth node d. A gate of the eighth transistor M8 is electrically connected to the fourth sub-control end V2_2 and the gate of the fourth transistor M4 through the fourth node d, a source of the eighth transistor M8 is electrically connected to the input end Vin1, and a drain of the eighth transistor M8 is electrically connected to the first sub-control end V1_1 through the first node a. The seventh transistor M7 and the eighth transistor M8 each are a P-type transistor. In the cross-coupled negative charge pump circuit, the seventh transistor M7 and the eighth transistor M8 form a positive feedback and are alternately conducted.

The first boost circuit 11 further includes a third capacitor C3, and the second boost circuit 12 further includes a fourth capacitor C4. The third capacitor C3 includes a fifth electrode and a sixth electrode, and the fourth capacitor includes a seventh electrode and an eighth electrode. The fifth electrode is electrically connected to the gate of the first transistor M1 and the drain of the third transistor M3 through the first node a, and the sixth electrode is electrically connected to the first sub-control end V1_1. The seventh electrode is electrically connected to the gate of the fourth transistor M4 and the drain of the sixth transistor M6 through the fourth node d, and the eighth electrode is electrically connected to the fourth sub-control end V2_2.

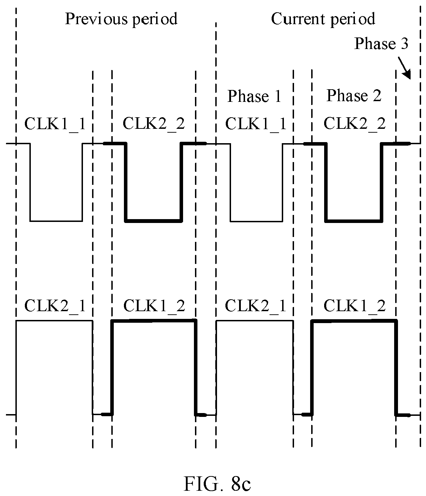

FIG. 8c is an operating timing diagram of a negative charge pump circuit. In addition, the first sub-clock signal CLK1_1 is at a high level in both phase 2 and phase 3, the second sub-clock signal CLK1_2 is at a low level in both phase 1 and phase 3, the third sub-clock signal CLK2_1 is at a low level in both phase 2 and phase 3, and the fourth sub-clock signal CLK2_2 is at a high level in both phase 1 and phase 3. It can be learned from the timing diagram that the negative charge pump circuit periodically operates, and an operating process of any period is as follows.

As shown in FIG. 8a and 8c, in phase 1, the first transistor M1, the fifth transistor M5, the sixth transistor M6, and the seventh transistor M7 are conducted, and the second transistor M2, the third transistor M3, the fourth transistor M4, and the eighth transistor M8 are cut off.

Specifically, the second sub-clock signal CLK1_2 input by the second sub-control end V1_2 to the gate of the second transistor M2 through the second node b is at a low level (-VDD), and the second transistor M2 is an N-type transistor. Therefore, the second transistor M2 is cut off.

As shown in FIG. 8a and FIG. 8c, the first sub-clock signal CLK1_1 input by the first sub-control end V1_1 to the gate of the first transistor M1 and the gate of the seventh transistor M7 through the first node a is at a low level (-VDD). The seventh transistor M7 is used to enhance a capability of the first sub-clock signal CLK1_1 to drive the gate of the first transistor M1. An operating process of the seventh transistor is: The seventh transistor M7 is conducted under control of a low level (-VDD), so that the fourth node d is fixed at a high level (0 V). However, because the seventh transistor M7 and the eighth transistor M8 form a positive feedback and are alternately conducted, the eighth transistor M8 is cut off, so that the first node a is fixed at a low level (-VDD), and the first transistor M1 electrically connected to the first node a is quickly conducted.

After the first transistor M1 is conducted, a power supply voltage input by the input end Vin may be received through the source. Because the input end Vin is electrically connected to the ground end, a voltage value of the power supply voltage is 0 V. The first transistor M1 inputs the power supply voltage 0 V to the first capacitor C1, to charge the first capacitor C1.

It should be understood that, in phase 3 of the previous period, the third sub-clock signal CLK2_1 at the third sub-control end V2_1 is at a low level (-VDD), and the first capacitor C1 is electrically connected between the third sub-control end V2_1 and the third node c. Therefore, in the current period, an initial voltage at the first capacitor C1 is -VDD. In phase 1 of the current period, after a voltage 0 V is input to the first capacitor C1 through the first transistor M1, the voltage at the first capacitor C1 is still -VDD.

According to the current formula of the P-type transistor, a conduction condition of the first transistor M1 serving as the P-type transistor is: A source-gate voltage difference Vsg_M1 of the first transistor M1 is greater than a threshold voltage Vthp of the P-type transistor (the threshold voltage Vthp is a positive number). If the third transistor M3 is conducted, the gate of the first transistor M1 is electrically connected to the source of the first transistor M1 through the third transistor M3, so that a voltage at the source of the first transistor M1 is the same as a voltage at the gate of the first transistor M1, in other words, the source-gate voltage difference Vsg_M1 of the first transistor M1 is equal to 0. This does not meet the conduction condition of the first transistor M1 and is contrary to the fact that the first transistor M1 is conducted under control of the first sub-clock signal CLK1_1 in phase 1. Therefore, in phase 1, the third transistor M3 is cut off.

Based on this, as shown in FIG. 8a and FIG. 8c, the third sub-clock signal CLK2_1 input by the third sub-control end V2_1 to the gate of the third transistor M3 through the third node c is at a high level (0 V), and the third transistor M3 is a P-type transistor. Therefore, the third transistor M3 is cut off.

When the third sub-control end V2_1 controls cut-off of the third transistor M3 through the third node c, the third sub-control end V2_1 further inputs the third sub-clock signal CLK2_1 to the fifth transistor M5 through the third node c, the third sub-clock signal CLK2_1 is at a high level (0 V), and the fifth transistor M5 is an N-type transistor. Therefore, the fifth transistor M5 is conducted. The second capacitor C2 discharges to the fifth transistor M5, and outputs a voltage -VDD through the fifth transistor M5 and the output end Vout, to implement voltage boosting. The voltage -VDD discharged by the second capacitor C2 to the fifth transistor M5 is a sum of a voltage 0 V input by the input end Vin to the second capacitor C2 through the fourth transistor M4 in phase 2 of the previous period and a voltage -VDD input to the second capacitor C2 through the second sub-control end V1_2 in phase 3 of the previous period. The operating processes of phase 2 and phase 3 of the previous period are the same as the operating processes of phase 2 and phase 3 of the current period. For details, refer to the following description of phase 2 and phase 3 of the current period.

The fourth sub-clock signal CLK2_2 input by the fourth sub-control end V2_2 to the gate of the fourth transistor M4 and the gate of the eighth transistor M8 through the fourth node d is at a high level (0 V). The eighth transistor M8 is used to enhance a capability of the fourth sub-clock signal CLK2_2 to drive the gate of the first transistor M1. An operating process of the eighth transistor is: The eighth transistor M8 is cut off under control of a high level, and the seventh transistor M7 is conducted, so that the fourth node d is fixed at a high level (0 V), and the fourth transistor M4 electrically connected to the fourth node d is quickly cut off.

The second sub-clock signal CLK1_2 input by the second sub-control end V1_2 to the gate of the sixth transistor M6 through the second node b is at a low level (-VDD), and the sixth transistor M6 is a P-type transistor. Therefore, the sixth transistor M6 is cut off. Because the fourth transistor M4 is cut off in phase 1, conduction of the sixth transistor M6 does not affect the fourth transistor M4.

As shown in FIG. 8a and 8c, in phase 2, the second transistor M2, the third transistor M3, the fourth transistor M4, and the eighth transistor M8 are conducted, and the first transistor M1, the fifth transistor M5, the sixth transistor M6, and the seventh transistor M7 are cut off.

Specifically, the first sub-clock signal CLK1_1 input by the first sub-control end V1_1 to the gate of the first transistor M1 and the gate of the seventh transistor M7 is at a high level (0 V). The seventh transistor M7 is used to enhance a capability of the first sub-clock signal CLK1_1 to drive the gate of the first transistor M1. An operating process of the seventh transistor is: The seventh transistor M7 is cut off under control of a high level, and the eighth transistor M8 is conducted, so that the first node a is fixed at a high level (0 V), and the first transistor M1 electrically connected to the first node a is quickly cut off.

The third sub-clock signal CLK2_1 input by the third sub-control end V2_1 to the gate of the third transistor M3 is at a low level (-VDD), and the third transistor M3 is a P-type transistor. Therefore, the third transistor M3 is conducted. Because the first transistor M1 is cut off in phase 2, conduction of the third transistor M3 does not affect the first transistor M1.

The second sub-clock signal CLK1_2 input by the second sub-control end V1_2 to the gate of the second transistor M2 is at a high level (0 V), and the second transistor M2 is an N-type transistor. Therefore, the second transistor M2 is conducted. The first capacitor C1 discharges to the second transistor M2, and outputs a voltage -VDD through the second transistor M2 and the output end Vout, to implement voltage boosting.

The fourth sub-clock signal CLK2_2 input by the fourth sub-control end V2_2 to the gate of the fourth transistor M4 and the gate of the eighth transistor M8 through the fourth node d is at a low level (-VDD). The eighth transistor M8 is used to enhance a capability of the fourth sub-clock signal CLK2_2 to drive the gate of the fourth transistor M4. An operating process of the eighth transistor is: The eighth transistor M8 is conducted under control of a low level, so that the first node a is fixed at a high level (0 V). However, because the seventh transistor M7 and the eighth transistor M8 form a positive feedback and are alternately conducted, the seventh transistor M7 is cut off, so that the fourth node d is fixed at a low level (-VDD), and the fourth transistor M4 electrically connected to the fourth node d is quickly conducted.

After the fourth transistor M4 is conducted, a power supply voltage input by the input end Vin may be received through the source. Because the input end Vin is electrically connected to the ground end, a voltage value of the power supply voltage is 0 V. The fourth transistor M4 inputs the power supply voltage 0 V to the second capacitor C2, to charge the second capacitor C2.

It should be understood that, in phase 3 of the previous period, the second sub-clock signal CLK1_2 at the second sub-control end V1_2 is at a low level (-VDD), and the second capacitor C2 is electrically connected between the second sub-control end V1_2 and the second node b. Therefore, in the current period, an initial voltage at the second capacitor C2 is -VDD. In phase 2 of the current period, after a voltage 0 V is input to the second capacitor C2, the voltage at the second capacitor C2 is still -VDD.

According to the current formula of the P-type transistor, a conduction condition of the fourth transistor M4 serving as the P-type transistor is: A source-gate voltage difference Vsg_M4 of the fourth transistor M4 is above a threshold voltage Vthp of the P-type transistor (the threshold voltage Vthp is a positive number). If the sixth transistor M6 is conducted, the gate of the fourth transistor M4 is electrically connected to the source of the fourth transistor M4 through the sixth transistor M6, so that a voltage at the source of the fourth transistor M4 is the same as a voltage at the gate of the fourth transistor M4, that is, the source-gate voltage difference Vsg_M4 of the fourth transistor M4 is equal to 0. This does not meet the conduction condition of the fourth transistor M4 and is contrary to the fact that the fourth transistor M4 is conducted under control of the fourth sub-clock signal CLK2_2 in phase 1. Therefore, in phase 2, the sixth transistor M6 is cut off.

Based on this, as shown in FIG. 8a and FIG. 8c, the second sub-clock signal CLK1_2 input by the second sub-control end V1_2 to the gate of the sixth transistor M6 through the second node b is at a high level (0 V), and the sixth transistor M6 is a P-type transistor. Therefore, the sixth transistor M6 is cut off.

As shown in FIG. 8a and FIG. 8c, in phase 3, the third sub-control end V2_1 is still at a low level (-VDD), and the third sub-control end V2_1 may continue to charge the first capacitor C1. The second sub-control end V1_2 is still at a low level (-VDD), and the second sub-control end V1_2 may continue to charge the second capacitor C2.

In addition, based on a typical cross-coupled negative charge pump circuit structure, the first transistor M1, the second transistor M2, the fourth transistor M4, and the fifth transistor M5 form a main part of the latched charge pump. The first sub-clock signal CLK1_1, the second sub-clock signal CLK1_2, the third sub-clock signal CLK2_1, and the fourth sub-clock signal CLK2_2 are adjusted as four-phase anti-aliasing clock signals, and a dead time operation is performed on each phase, so that the first boost circuit 11 and the second boost circuit 12 alternately operate in phase 1 and phase 2. This reduces electric leakage when the negative charge pump circuit operates.

An example in which the charge pump circuit is a negative charge pump circuit is still used. As shown in FIG. 8b, when the negative charge pump is in a non-operating state, a voltage at the first sub-control end V1_1 is a first sub-fixed voltage, a voltage at the second sub-control end V1_2 is a second sub-fixed voltage, a voltage at the third sub-control end V2_1 is a third sub-fixed voltage, and a voltage at the fourth sub-control end V2_2 is a fourth sub-fixed voltage. The first sub-fixed voltage, the second sub-fixed voltage, the third sub-fixed voltage, and the fourth sub-fixed voltage may be the same, or may be different. Optionally, the first sub-fixed voltage, the second sub-fixed voltage, the third sub-fixed voltage, and the fourth sub-fixed voltage are the same.

For example, the first sub-control end V1_1, the second sub-control end V1_2, the third sub-control end V2_1, and the fourth sub-control end V2_2 each are electrically connected to the ground end, and the first sub-fixed voltage, the second sub-fixed voltage, the third sub-fixed voltage, and the fourth sub-fixed voltage each are 0 V; or the first sub-control end V1_1, the second sub-control end V1_2, the third sub-control end V2_1, and the fourth sub-control end V2_2 each are electrically connected to the operating voltage end, and the first sub-fixed voltage, the second sub-fixed voltage, the third sub-fixed voltage, and the fourth sub-fixed voltage each are a VDD.

For ease of description, the following uses an example in which the first sub-control end V1_1, the second sub-control end V1_2, the third sub-control end V2_1, and the fourth sub-control end V2_2 each are electrically connected to the ground end, and voltages of the first sub-fixed voltage, the second sub-fixed voltage, the third sub-fixed voltage, and the fourth sub-fixed voltage each are 0 V for description.

As the name implies, the first sub-fixed voltage, the second sub-fixed voltage, the third sub-fixed voltage, and the fourth sub-fixed voltage each are a fixed voltage value. Different from the clock signal, the fixed voltage has no signal fluctuation (in other words, there is no power down). Therefore, when the negative charge pump is in the non-operating state, voltages at the second electrode of the first capacitor C1, the fourth electrode of the second capacitor C2, the sixth electrode of the third capacitor C3, and the eighth electrode of the fourth capacitor C4 each are 0 V, and the first electrode of the first capacitor C1, the third electrode of the second capacitor C2, the fifth electrode of the third capacitor C3, and the eighth electrode of the fourth capacitor C4 each are in a floating state.

Further, the first electrode of the first capacitor C1 is electrically connected to the gate of the third transistor M3 and the gate of the fifth transistor M5 through the third node c, the third electrode of the second capacitor C2 is electrically connected to the gate of the second transistor M2 and the gate of the sixth transistor M6 through the second node b, the fifth electrode of the third capacitor C3 is electrically connected to the gate of the first transistor M1 and the gate of the seventh transistor M7 through the first node a, and the seventh electrode of the fourth capacitor C4 is electrically connected to the gate of the fourth transistor M4 and the gate of the eighth transistor M8 through the fourth node d. Therefore, when the first electrode of the first capacitor C1, the third electrode of the second capacitor C2, the fifth electrode of the third capacitor C3, and the eighth electrode of the fourth capacitor C4 each are in a floating state, conduction statuses of the first transistor M1 to the eighth transistor M8 are uncertain.

It is assumed that the power supply voltage is boosted through the first boost circuit 11, the first transistor M1 and the second transistor M2 are conducted, and the third transistor M3 and the fifth transistor M5 are cut off. The first transistor M1 operates in a saturation region, the second transistor M2 operates in a linear region, and the third transistor M3 and the fifth transistor M5 operate in a cut-off region.

If the first transistor M1 is conducted, the source-gate voltage difference Vsg_M1 of the first transistor M1 needs to satisfy Formula 1:

$$V_{sg\_M1} = 0-\mathrm{Va} > V_{thp} \quad \text{(Formula 1)}.$$

0 indicates that a voltage that is input by the input end Vin and that is received by the source of the first transistor M1 is 0 V, and Va indicates a voltage at the first node a.

Further, if the first transistor M1 operates in the saturation region, a source-drain voltage difference Vsd_M1 of the first transistor M1 needs to satisfy Formula 2:

$$V_{sd\_M1} = 0-\mathrm{Vc} > V_{sg\_M1}-V_{thp} = -\mathrm{Va}-V_{thp} \quad \text{(Formula 2)}.$$

Vc indicates a voltage at the third node c.

If the second transistor M2 operates in the linear region, a gate-drain voltage difference Vgd_M2 of the second transistor M2 needs to satisfy Formula 3:

$$V_{gd\_M2} = \mathrm{V2}-V_o > V_{thn} \quad \text{(Formula 3)}.$$

The drain of the second transistor M2 is electrically connected to the output end Vout, Vo indicates a voltage at the output end Vo, and Vthn indicates a threshold voltage of the N-type transistor.

If the third transistor M3 operates in the cut-off region, a source-gate voltage difference Vsg_M3 of the third transistor M3 needs to satisfy Formula 4:

$$V_{sg\_M3} = 0 - Vc < V_{thp} \quad \text{(Formula 4)}.$$

If the fifth transistor M5 operates in the cut-off region, a source-gate voltage difference Vsg_M3 of the fifth transistor M5 needs to satisfy Formula 4:

$$V_{sg\_M5} = 0 - Vo < V_{thn} \quad \text{(Formula 5)}.$$

Further, the following is obtained through derivation according to Formula 4 and Formula 5:

$$-V_{thp} < \mathrm{Vc} < V_{thn} + V_o \quad \text{(Formula 6)}.$$

$V_{thp}+V_{thn} > -V_o$ may be obtained according to Formula 6.

The negative charge pump circuit requires a power supply of -3.3 V to -2 V for a CIS. In other words, a voltage -VDD output by the negative charge pump circuit usually ranges from -3.3 V to -2 V. For example, the negative charge pump circuit requires a power supply of -VDD=-2.8 V for a CIS, or the negative charge pump circuit requires a power supply of -VDD=-3.3 V for a CIS. For example, the negative charge pump circuit requires a power supply of -VDD=-2.8 V for the CIS, and $V_{thp}+V_{thn} > -V_o$=2.8 V.

However, for a current standard CMOS process for preparing the CIS, regardless of whether the CMOS is an N-type transistor or a P-type transistor, neither a threshold voltage Vthn of the N-type transistor nor a threshold voltage Vthp of the P-type transistor exceeds 1 V. Further, a sum of the threshold voltage Vthn of the N-type transistor and the threshold voltage Vthp of the P-type transistor cannot exceed 2 V. Therefore, $V_{thp}+V_{thn} > -V_o$=2 V is not established.

In addition, it is reversely proved that it is not established when the negative charge pump circuit is in the non-operating state, the first transistor M1 is conducted and the third transistor M3 is cut off. It can be learned from the foregoing description that, to cut off the first transistor M1, the third transistor M3 may be conducted, that is, when the third transistor M3 is conducted, the source and the gate of the first transistor M1 are conducted, and the source-gate voltage difference Vsg_M1 of the first transistor M1 is 0, so that the first transistor M1 is cut off. In other words, the cut-off signal is input to the gate of the first transistor M1 through the conducted third transistor M3, so that the first transistor M1 is cut off.

The first transistor M1 is used as a part of the first boost circuit 11, and when the first transistor M1 is cut off, the first boost circuit 11 is also disconnected. In this way, the backflow current Iout cannot be input from the negative charge pump circuit in the non-operating state to the negative charge pump circuit in the operating state through the first boost circuit 11.

Similarly, it is assumed that the power supply voltage is boosted through the second boost circuit 12. According to the foregoing formula, a conclusion that the fourth transistor M4 is conducted and the sixth transistor M6 is cut off being not established, and a conclusion that the fifth transistor M5 is cut off by using the conducted sixth transistor M6 may also be obtained through derivation. In this way, the second boost circuit 12 is cut off, and the backflow current Iout cannot be input from the negative charge pump circuit in the non-operating state to the negative charge pump circuit in the operating state through the second boost circuit 12. Details are not described herein again.

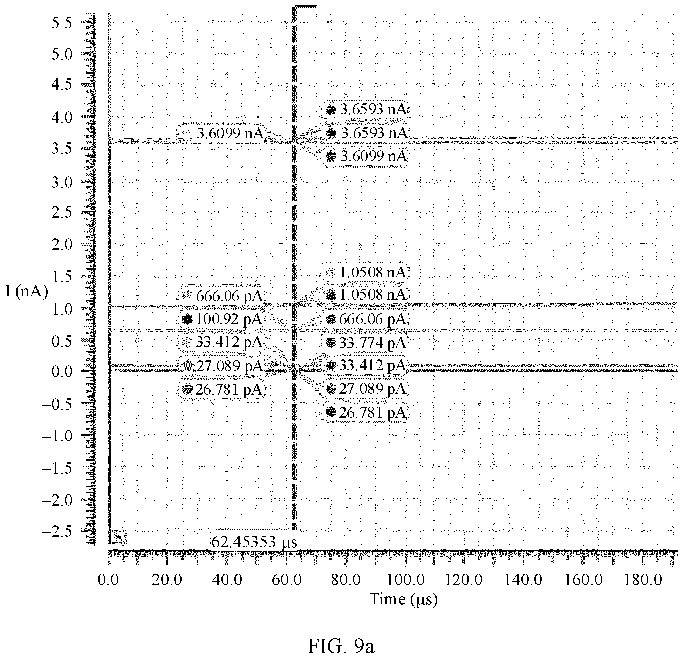

FIG. 9a is a diagram of a change of backflow currents Iout output by the negative charge pump circuit in the non-operating state at different process voltages and temperatures (process voltage and temperature, PVT) in a solution according to an embodiment of this application. The following table 3 may be obtained from FIG. 9a:

**Table 3**

| | Minimum value Min | Maximum value Max |
|---|---|---|
| Average value of the backflow currents Iout | 249.9 nA | 362.7 nA |
| Backflow current Iout | 26.78 pA | 3.6 nA |

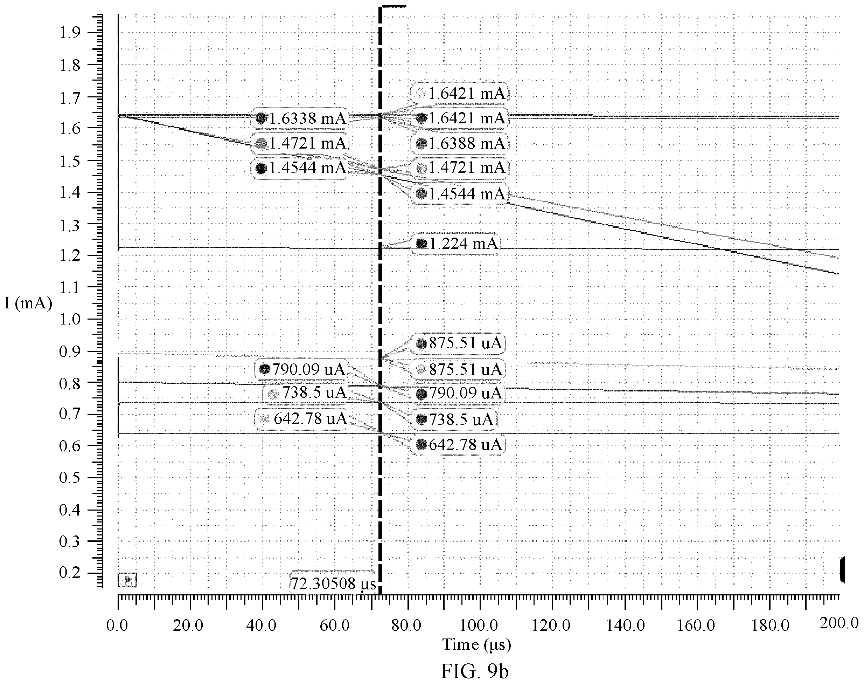

FIG. 9b is a diagram of a change of backflow currents Iout output by the negative charge pump circuit in the non-operating state at different process voltages and temperatures in a solution that the third transistor M3 and the sixth transistor M6 are not included. The following Table 4 may be obtained from FIG. 9b:

**Table 4**

| | Minimum value Min | Maximum value Max |
|---|---|---|
| Average value of the backflow currents Iout | 642.9 $\mu$A | 1.642 mA |
| Backflow current Iout | 642.1 $\mu$A | 1.64 mA |

It can be learned from Table 3 and Table 4 that, in the solution of this embodiment of this application, the maximum value of the backflow current Iout output by the negative charge pump circuit in the non-operating state is 3.6 nA. In the solution that the third transistor M3 and the sixth transistor M6 are not included, the minimum value of the backflow current Iout output by the negative charge pump circuit in the non-operating state is 642.1 $\mu$A (about 0.64 mA). The maximum backflow current Iout in this embodiment of this application is less than the minimum backflow current Iout in the solution that the third transistor M3 and the sixth transistor M6 are not included. This indicates that the backflow current Iout is greatly reduced in the negative charge pump circuit in this application.

It should be understood that the backflow current Iout cannot be input to the negative charge pump circuit in the operating state through the first boost circuit 11 and the second boost circuit 12 of the negative charge pump circuit in the non-operating state. The backflow current Iout of 26.78 pA to 3.6 nA shown in Table 1 may be a leakage current of each component in the negative charge pump circuit.

In some possible implementations, in this embodiment of this application, voltage switching at the first sub-control end V1_1, the second sub-control end V1_2, the third sub-control end V2_1, and the fourth sub-control end V2_2 may be implemented by using a switch or through a logic circuit. For example, the negative charge pump circuit further includes a first switch, a second switch, a third switch, and a fourth switch. The first switch is electrically connected between the first sub-control end V1_1 and the ground end and the first clock generation circuit, the second switch is electrically connected between the second sub-control end V1_2 and the ground end and the second clock generation circuit, the third switch is electrically connected between the third sub-control end V2_1 and the ground end and a third clock generation circuit, and the fourth switch is electrically connected between the fourth sub-control end V2_2 and the ground end and a fourth clock generation circuit.

When the negative charge pump circuit is in an operating state, the first sub-control end V1_1 is connected to the first clock generation circuit through the first switch, and the first clock generation circuit inputs the first sub-clock signal CLK1_1 to the first sub-control end V1_1 through the first switch. When the negative charge pump circuit is in an operating state, the first sub-control end V1_1 is connected to the ground end through the first switch, and the ground end inputs a first sub-fixed voltage 0 V to the first sub-control end V1_1 through the first switch.

Similarly, when the negative charge pump circuit is in an operating state, the second sub-control end V1_2 is connected to the second clock generation circuit through the second switch, and the second clock generation circuit inputs the second sub-clock signal CLK1_2 to the second sub-control end V1_2 through the second switch. When the negative charge pump circuit is in an operating state, the second sub-control end V1_2 is connected to the ground end through the second switch, and the ground end inputs a second sub-fixed voltage 0 V to the second sub-control end V1_2 through the second switch.

Similarly, when the negative charge pump circuit is in an operating state, the third sub-control end V2_1 is connected to the third clock generation circuit through the third switch, and the third clock generation circuit inputs the third sub-clock signal CLK2_1 to the third sub-control end V2_1 through the third switch. When the negative charge pump circuit is in an operating state, the third sub-control end V2_1 is connected to the ground end through the third switch, and the ground end inputs a third sub-fixed voltage 0 V to the third sub-control end V2_1 through the third switch.

Similarly, when the negative charge pump circuit is in an operating state, the fourth sub-control end V2_2 is connected to the fourth clock generation circuit through the fourth switch, and the fourth clock generation circuit inputs the fourth sub-clock signal CLK2_2 to the fourth sub-control end V2_2 through the fourth switch. When the negative charge pump circuit is in an operating state, the fourth sub-control end V2_2 is connected to the ground end through the fourth switch, and the ground end inputs a fourth sub-fixed voltage 0 V to the fourth sub-control end V2_2 through the fourth switch.

Certainly, voltage switching at the first control end V1 and the second control end V2 may alternatively be implemented through another logic circuit. The logic circuit may be, for example, an AND gate, a NOT gate, or a NAND gate.

In the foregoing, operating principles of the positive charge pump in the operating state and the non-operating state are described by using an example in which the charge pump circuit as a positive charge pump. In some other possible implementations, the charge pump circuit may alternatively be a positive charge pump. As shown in FIG. 4b and FIG. 5b, a connection manner of each component in the positive charge pump circuit is the same as a connection manner of each component in the negative charge pump circuit, but types of a first transistor M1 to a sixth transistor M6 are different. That is, the first transistor M1, the third transistor M3, the fourth transistor M4, and the sixth transistor M6 each may be an N-type transistor, and the second transistor M2 and the fifth transistor M5 each may be a P-type transistor. In addition, an input end Vin is electrically connected to an operating voltage end, and is configured to receive an operating voltage VDD.

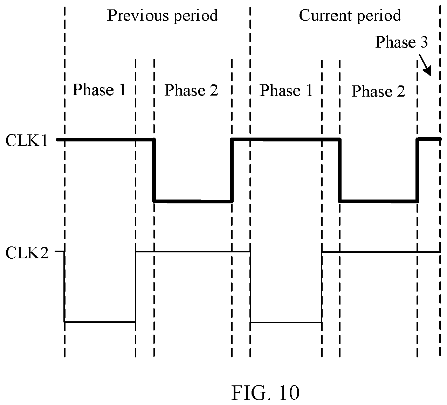

FIG. 10 is an operating timing diagram of a positive charge pump circuit. It can be learned from the timing diagram that the positive charge pump circuit periodically operates, and an operating process of any period is as follows.

As shown in FIG. 4b and FIG. 10, in phase 1, the first transistor M1, the fifth transistor M5, and the sixth transistor M6 are conducted, and the second transistor M2, the third transistor M3, and the fourth transistor M4 are cut off.

Specifically, a first clock signal CLK1 input by a first control end V1 to a gate of the second transistor M2 through a second node b is at a high level (VDD), and the second transistor M2 is a P-type transistor. Therefore, the second transistor M2 is cut off.

As shown in FIG. 4b and FIG. 10, the first clock signal CLK1 input by the first control end V1 to a gate of the first transistor M1 through the second node b and a first node a is at a high level (VDD), and the first transistor M1 is an N-type transistor. Therefore, the first transistor M1 is conducted, and the first transistor M1 receives, through a source, a power supply voltage input by the input end Vin. Because the input end Vin is electrically connected to the operating voltage end, and is configured to receive an operating voltage VDD, the first transistor M1 inputs the power supply voltage VDD to a first capacitor C1, to charge the first capacitor C1.

It should be understood that, in phase 3 of the previous period, a second clock signal CLK2 at a second control end V2 is at a high level (VDD), and the first capacitor C1 is electrically connected between the second control end V2 and a third node c. Therefore, in the current period, an initial voltage at the first capacitor C1 is VDD. In phase 1 of the current period, after the voltage VDD is input to the first capacitor C1 through the first transistor M1, the voltage at the first capacitor C1 is 2VDD.

According to the current formula of the N-type transistor, a conduction condition of the first transistor M1 serving as the N-type transistor is: A gate-source voltage difference Vgs_M1 of the first transistor M1 is above a threshold voltage Vthn of the N-type transistor (the threshold voltage Vthn is a positive number). If the third transistor M3 is conducted, the gate of the first transistor M1 is electrically connected to the source of the first transistor M1 through the third transistor M3, so that a voltage at the source of the first transistor M1 is the same as a voltage at the gate of the first transistor M1, that is, the source-gate voltage difference Vgs_M1 of the first transistor M1 is equal to 0. This does not meet the conduction condition of the first transistor M1 and is contrary to the fact that the first transistor M1 is conducted under control of the first clock signal CLK1 in phase 1. Therefore, in phase 1, the third transistor M3 is cut off.

Based on this, as shown in FIG. 4b and FIG. 10, the second clock signal CLK2 input by the second control end V2 to the gate of the third transistor M3 through the third node c is at a low level (0 V), and the third transistor M3 is an N-type transistor. Therefore, the third transistor M3 is cut off.

When the second control end V2 controls cut-off of the third transistor M3 through the third node c, the second control end V2 further inputs the second clock signal CLK2 to the fifth transistor M5 through the third node c, the second clock signal CLK2 is at a low level (0 V), and the fifth transistor M5 is a P-type transistor. Therefore, the fifth transistor M5 is conducted. The second capacitor C2 discharges to the fifth transistor M5, and outputs a voltage 2VDD through the fifth transistor M5 and the output end Vout, to implement voltage boosting. The voltage 2VDD discharged by the second capacitor C2 to the fifth transistor M5 is a sum of a voltage VDD input by the input end Vin to the second capacitor C2 through the fourth transistor M4 in phase 2 of the previous period and a voltage VDD input to the second capacitor C2 through the first control end V1 in phase 3 of the previous period. The operating processes of phase 2 and phase 3 of the previous period are the same as the operating processes of phase 2 and phase 3 of the current period. For details, refer to the following description of phase 2 and phase 3 of the current period.

The second clock signal CLK2 input by the second control end V2 to the gate of the fourth transistor M4 through the fourth node d is at a low level (0 V), and the fourth transistor M4 is an N-type transistor. Therefore, the fourth transistor M4 is cut off.

The first clock signal CLK1 input by the first control end V1 to the gate of the sixth transistor M6 through the second node b is at a high level (VDD), and the sixth transistor M6 is an N-type transistor. Therefore, the sixth transistor M6 is cut off. Because the fourth transistor M4 is cut off in phase 1, conduction of the sixth transistor M6 does not affect the fourth transistor M4.

As shown in FIG. 4b and FIG. 10, in phase 2, the second transistor M2, the third transistor M3, and the fourth transistor M4 are conducted, and the first transistor M1, the fifth transistor M5, and the sixth transistor M6 are cut off.

Specifically, the first clock signal CLK1 input by the first control end V1 to the gate of the first transistor M1 is at a low level (0 V), and the first transistor M1 is an N-type transistor. Therefore, the first transistor M1 is cut off.

The second clock signal CLK2 input by the second control end V2 to the gate of the third transistor M3 is at a high level (VDD), and the third transistor M3 is an N-type transistor. Therefore, the third transistor M3 is conducted. Because the first transistor M1 is cut off in phase 2, conduction of the third transistor M3 does not affect the first transistor M1.

The first clock signal CLK1 input by the first control end V1 to the gate of the second transistor M2 is at a low level (0 V), and the second transistor M2 is a P-type transistor. Therefore, the second transistor M2 is conducted. The first capacitor C1 discharges to the second transistor M2, and outputs a voltage 2VDD through the second transistor M2 and the output end Vout, to implement voltage boosting.

The second clock signal CLK2 input by the second control end V2 to the gate of the fourth transistor M4 through the fourth node d is at a high level (VDD), and the fourth transistor M4 is an N-type transistor. Therefore, the fourth transistor M4 is conducted, and the fourth transistor M4 receives, through the source, the power supply voltage input by the input end Vin. Because the input end Vin is electrically connected to the operating voltage end and is configured to receive an operating voltage VDD, the fourth transistor M4 inputs the power supply voltage VDD to the second capacitor C2, to charge the second capacitor C2.

It should be understood that, in phase 3 of the previous period, the first clock signal CLK1 at the first control end V1 is at a high level (VDD), and the second capacitor C2 is electrically connected between the first control end V1 and the second node b. Therefore, in the current period, an initial voltage at the second capacitor C2 is VDD. In phase 2 of the current period, after the voltage VDD is input to the second capacitor C2, the voltage at the second capacitor C2 is 2VDD.

According to the current formula of the N-type transistor, a conduction condition of the fourth transistor M4 serving as the N-type transistor is: A source-gate voltage difference Vgs_M4 of the fourth transistor M4 is above a threshold voltage Vthn of the N-type transistor (the threshold voltage Vthn is a positive number). If the sixth transistor M6 is conducted, the gate of the fourth transistor M4 is electrically connected to the source of the fourth transistor M4 through the sixth transistor M6, so that a voltage at the source of the fourth transistor M4 is the same as a voltage at the gate of the fourth transistor M4, that is, the source-gate voltage difference Vgs_M4 of the fourth transistor M4 is equal to 0. This does not meet the conduction condition of the fourth transistor M4 and is contrary to the fact that the fourth transistor M4 is conducted under control of the second clock signal CLK2 in phase 1. Therefore, in phase 2, the sixth transistor M6 is cut off.

Based on this, as shown in FIG. 4b and FIG. 10, the first clock signal CLK1 input by the first control end V1 to the gate of the sixth transistor M6 through the second node b is at a low level (0 V), and the sixth transistor M6 is an N-type transistor. Therefore, the sixth transistor M6 is cut off.

As shown in FIG. 4b and FIG. 10, in phase 3, the second control end V2 is still at a high level (VDD), and the second control end V2 may continue to charge the first capacitor C1. The first control end V1 is still at a high level (VDD), and the first control end V1 may continue to charge the second capacitor C2.

An example in which the charge pump circuit is a positive charge pump circuit is still used. As shown in FIG. 5b, when the positive charge pump is in a non-operating state, the voltage at the first control end V1 is a first fixed voltage, the voltage at the first control end V1 is a first fixed voltage, and the voltage at the second control end V2 is a second fixed voltage. The first fixed voltage may be the same as or different from the second fixed voltage. Optionally, the first fixed voltage is the same as the second fixed voltage. For example, the first control end V1 and the second control end V2 each are electrically connected to the ground end, and the first fixed voltage and the second fixed voltage each are 0 V; or the first control end V1 and the second control end V2 each are electrically connected to an operating voltage end, and the first fixed voltage and the second fixed voltage each are a VDD.

Certainly, the first fixed voltage and the second fixed voltage may alternatively be other values. This is not limited in this embodiment of this application. For ease of description, the following uses an example in which the first control end V1 and the second control end V2 each are electrically connected to the ground end, and the first fixed voltage and the second fixed voltage each are 0 V for description.

As the name implies, the first fixed voltage and the second fixed voltage each are a fixed voltage value. Different from the clock signal, the fixed voltage has no signal fluctuation (in other words, there is no power down). Therefore, when the positive charge pump is in the non-operating state, voltages at the second electrode of the first capacitor C1 and the fourth electrode of the second capacitor C2 each are 0 V, and the first electrode of the first capacitor C1 and the third electrode of the second capacitor C2 each are in a floating state.

Further, the first electrode of the first capacitor C1 is electrically connected to the gate of the third transistor M3, the gate of the fourth transistor M4, and the gate of the fifth transistor M5 through the third node c, and the third electrode of the second capacitor C2 is electrically connected to the gate of the first transistor M1, the gate of the second transistor M2, and the gate of the sixth transistor M6 through the second node b. Therefore, when the first electrode of the first capacitor C1 and the third electrode of the second capacitor C2 each are in a floating state, conduction statuses of the first transistor M1 to the sixth transistor M6 are uncertain. If a first transistor and a second transistor of a same positive charge pump circuit are conducted, and/or a fourth transistor and a fifth transistor of a same positive charge pump circuit are conducted, the foregoing backflow current is input from a positive charge pump circuit in an operating state to a positive charge pump circuit in a non-operating state.

It is assumed that the power supply voltage is boosted through the first boost circuit 11, the first transistor M1 and the second transistor M2 are conducted, and the third transistor M3 and the fifth transistor M5 are cut off. The first transistor M1 operates in a saturation region, the second transistor M2 operates in a linear region, and the third transistor M3 and the fifth transistor M5 operate in a cut-off region.

If the first transistor M1 is conducted, the source-gate voltage difference Vgs_M1 of the first transistor M1 needs to satisfy Formula 7:

$$V_{gs\_M1} = \text{Va} - \text{VDD} > V_{thn} \quad \text{(Formula 7)}.$$

VDD indicates that a voltage that is input by the input end Vin and that is received by the source of the first transistor M1 is VDD, and Va indicates a voltage at the first node a.

Further, if the first transistor M1 operates in the saturation region, a source-drain voltage difference Vsd_M1 of the first transistor M1 needs to satisfy Formula 8:

$$V_{sd\_M1} = \text{VDD} - \text{Vc} > V_{gs\_M1} - V_{thn} = \text{Va} - \text{VDD} - V_{thn} \quad \text{(Formula 8)}.$$

Vc indicates a voltage at the third node c.

If the second transistor M2 operates in the linear region, the second transistor M2 needs to satisfy Formula 9:

$$V2{-}V_o{>}V_{thp} \quad \text{(Formula 9)}.$$

The drain of the second transistor M2 is electrically connected to the output end Vout, and Vo indicates a voltage at the output end Vo.

If the third transistor M3 operates in the cut-off region, a source-gate voltage difference Vgs_M3 of the third transistor M3 needs to satisfy Formula 10:

$$V_{gs\_M3} = Vc - \text{VDD} < V_{thn} \quad \text{(Formula 10)}.$$

If the fifth transistor M5 operates in the cut-off region, the fifth transistor M5 needs to satisfy Formula 11:

$$Vo - Vc < V_{thp} \quad \text{(Formula 11)}.$$

Further, the following is obtained through derivation according to Formula 10 and Formula 11:

$$Vo - V_{thp}{<}Vc{<}V_{thp} + \text{VDD} \quad \text{(Formula 12)}.$$

$Vo\text{-}VDD{<}V_{thp}{+}V_{thn}$ may be obtained according to Formula 12.

However, in the positive charge pump circuit, the voltage Vo output by the first boost circuit 11 is 2DD. Therefore, $Vo\text{-}VDD{<}V_{thp}{+}V_{thn}$ may be represented as VDD${<}V_{thp}{+}V_{thn}$.

Further, the positive charge pump circuit requires a power supply of 2 V to 3.3 V for the CIS. For example, the positive charge pump circuit requires a power supply of VDD=2.8 V for the CIS, or the positive charge pump circuit requires a power supply of VDD=3.3 V for the CIS. For example, the positive charge pump circuit requires a power supply of VDD=2.8 V for the CIS, and $V_{thp}{+}V_{thn} > VDD$=2.8 V.

However, for a current standard CMOS process for preparing the CIS, regardless of whether the CMOS is an N-type transistor or a P-type transistor, neither a threshold voltage Vthn of the N-type transistor nor a threshold voltage Vthp of the P-type transistor exceeds 1 V. Further, a sum of the threshold voltage Vthn of the N-type transistor and the threshold voltage Vthp of the P-type transistor cannot exceed 2 V. Therefore, $V_{thp}{+}V_{thn} > VDD$=2 V is not established.

In addition, it is reversely proved that it is not established when the positive charge pump circuit is in the non-operating state, the first transistor M1 is conducted and the third transistor M3 is cut off. It can be learned from the foregoing description that, to cut off the first transistor M1, the third transistor M3 may be conducted, that is, when the third transistor M3 is conducted, the source and the gate of the first transistor M1 are conducted, and the gate-source voltage difference Vgs_M1 of the first transistor M1 is 0, so that the first transistor M1 is cut off. In other words, the cut-off signal is input to the gate of the first transistor M1 through the conducted third transistor M3, so that the first transistor M1 is cut off.

The first transistor M1 is used as a part of the first boost circuit 11, and when the first transistor M1 is cut off, the first boost circuit 11 is also disconnected. In this way, the backflow current Iout cannot be input from the positive charge pump circuit in the operating state to the positive charge pump circuit in the non-operating state through the first boost circuit 11.

Similarly, it is assumed that the power supply voltage is boosted through the second boost circuit 12. According to the foregoing formula, a conclusion that the fourth transistor M4 is conducted and the sixth transistor M6 is cut off being not established, and a conclusion that the fifth transistor M5 is cut off by using the conducted sixth transistor M6 may also be obtained through derivation. In this way, the second boost circuit 12 is cut off, and the backflow current Iout cannot be input from the positive charge pump circuit in the operating state to the positive charge pump circuit in the non-operating state through the second boost circuit 12. Details are not described herein again.

In some possible implementations, in this embodiment of this application, voltage switching at the first control end V1 and the second control end V2 may be implemented by using a switch or through a logic circuit, so that the voltage at the first control end V1 is the first clock signal CLK1 or the first fixed voltage, and the voltage at the second control end V2 is the second clock signal CLK2 or the second fixed voltage. For details, refer to an implementation of the negative charge pump circuit in the foregoing embodiment.

In addition to preventing the backflow current Iout from being transmitted in the positive charge pump circuit, the third transistor M3 may further reduce the source-gate voltage difference Vsg_M1 of the first transistor M1 at a moment when the positive charge pump circuit is just connected. This prevents the source-gate voltage difference Vsg_M1 of the first transistor M1 from exceeding the withstand voltage limit 3.3 V of the CIS.

In a solution that the third transistor M3 and the sixth transistor M6 are not included, at the moment when the positive charge pump circuit is just conducted, the first transistor M1 is conducted, and the source-gate voltage difference Vsg_M1 of the first transistor M1 is above the standard withstand voltage limit 3.3 V.

However, in the solution in this embodiment of this application, because the source of the third transistor M3 is electrically connected to the operating voltage end through the input end Vin, a drain of the third transistor M3 is electrically connected to the gate of the first transistor M1. Therefore, at the moment when the positive charge pump circuit is just connected, the third transistor M3 can be instantaneously conducted, receive, through the source, the voltage VDD input from the operating voltage end, and input the voltage VDD to the gate of the first transistor M1, to pull up the voltage at the gate of the first transistor M1. This reduces the source-gate voltage difference Vsg_M1 of the first transistor M1, and enables the source-gate voltage difference Vsg_M1 of the first transistor M1 below the standard withstand voltage limit 3.3 V.

Similarly, at the moment when the positive charge pump circuit is just connected, in the solution of this embodiment of this application, the sixth transistor M6 can be instantaneously conducted, receive the voltage VDD through the source, and input the voltage VDD to the gate of the fourth transistor M4, to pull up the voltage at the gate of the fourth transistor M4. This reduces a source-gate voltage difference Vsg_M4 of the fourth transistor M4, and enables the source-gate voltage difference Vsg_M4 of the fourth transistor M4 below the standard withstand voltage limit 3.3 V.

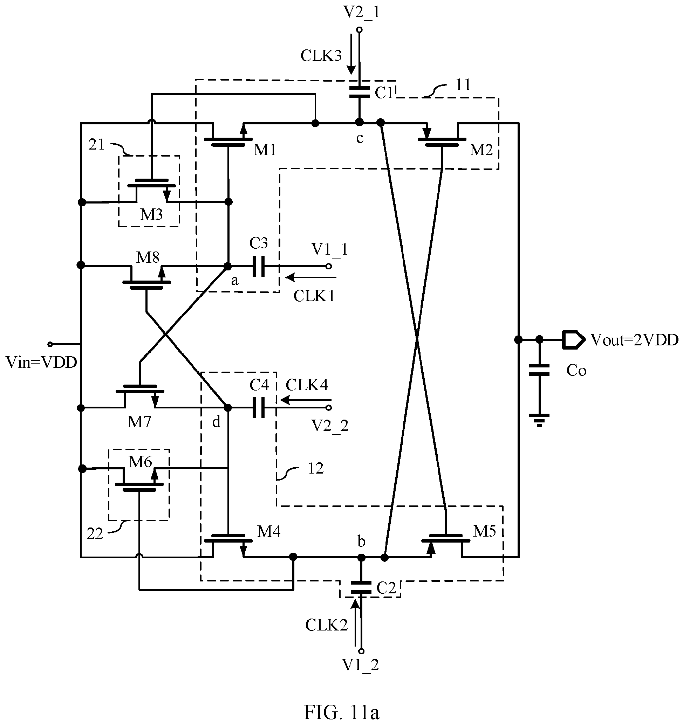

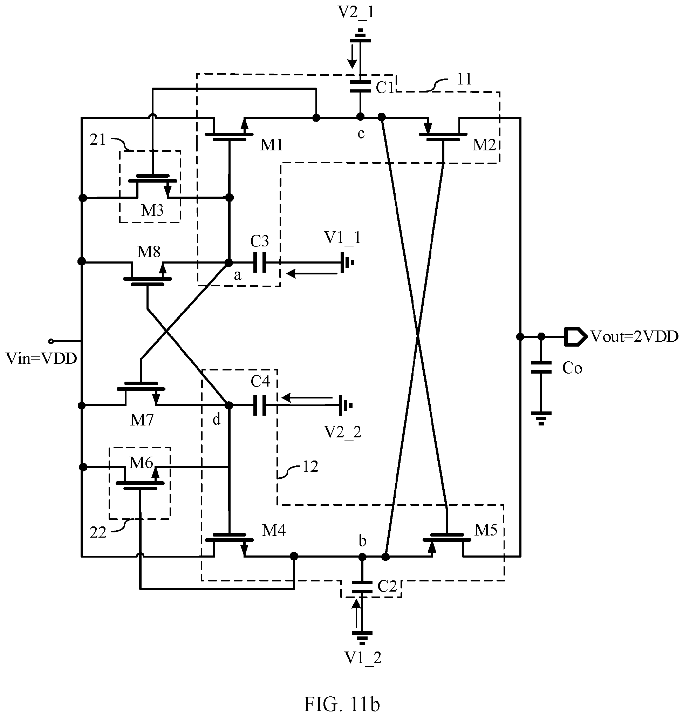

In some embodiments, as shown in FIG. 11a and FIG. 11b, the positive charge pump is a cross-coupled positive charge pump circuit, and the positive charge pump circuit may further include a seventh transistor M7 and an eighth transistor M8. The first control end V1 includes a first sub-control end V1_1 and a second sub-control end V1_2, and the second control end V2 includes a third sub-control end V2_1 and a fourth sub-control end V2_2.

The first sub-control end V1_1 is electrically connected to the gate of the first transistor M1 through the first node a, to input, in the operating state, the first sub-clock signal CLK1_1 to the gate of the first transistor M1. The second sub-control end V1_2 is electrically connected to the gate of the second transistor M2 and the gate of the sixth transistor M6 through the second node b, to input, in the operating state, the second sub-clock signal CLK1_2 to the gate of the second transistor M2 and the gate of the sixth transistor M6. The third sub-control end V2_1 is electrically connected to the gate of the third transistor M3 and the gate of the fifth transistor M5 through the third node c, to input, in the operating state, the third sub-clock signal CLK2_1 to the gate of the third transistor M3 and the gate of the fifth transistor M5. The fourth sub-control end V2_2 is electrically connected to the gate of the fourth transistor M4 through the fourth node d, to input, in the operating state, the fourth sub-clock signal CLK2_2 to the gate of the fourth transistor M4.

A gate of the seventh transistor M7 is electrically connected to the first sub-control end V1_1 and the gate of the first transistor M1 through the first node a, a source of the seventh transistor M7 is electrically connected to the input end Vin1, and a drain of the seventh transistor M7 is electrically connected to the fourth sub-control end V2_2 through the fourth node d. A gate of the eighth transistor M8 is electrically connected to the fourth sub-control end V2_2 and the gate of the fourth transistor M4 through the fourth node d, a source of the eighth transistor M8 is electrically connected to the input end Vin1, and a drain of the eighth transistor M8 is electrically connected to the first sub-control end V1_1 through the first node a. The seventh transistor M7 and the eighth transistor M8 each are a P-type transistor. In the cross-coupled positive charge pump circuit, the seventh transistor M7 and the eighth transistor M8 form a positive feedback and are alternately conducted.

The first boost circuit 11 further includes a third capacitor C3, and the second boost circuit 12 further includes a fourth capacitor C4. The third capacitor C3 includes a fifth electrode and a sixth electrode, and the fourth capacitor includes a seventh electrode and an eighth electrode. The fifth electrode is electrically connected to the gate of the first transistor M1 and the drain of the third transistor M3 through the first node a, and the sixth electrode is electrically connected to the first sub-control end V1_1. The seventh electrode is electrically connected to the gate of the fourth transistor M4 and the drain of the sixth transistor M6 through the fourth node d, and the eighth electrode is electrically connected to the fourth sub-control end V2_2.

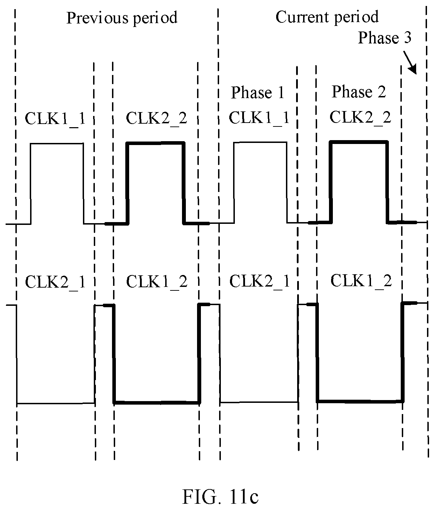

FIG. 11c is an operating timing diagram of a positive charge pump circuit. In addition, the first sub-clock signal CLK1_1 is at a low level in both phase 2 and phase 3, the second sub-clock signal CLK1_2 is at a high level in both phase 1 and phase 3, the third sub-clock signal CLK2_1 is at a high level in both phase 2 and phase 3, and the fourth sub-clock signal CLK2_2 is at a low level in both phase 1 and phase 3. It can be learned from the timing diagram that the positive charge pump circuit periodically operates, and an operating process of any period is as follows.

As shown in FIG. 11a and 11c, in phase 1, the first transistor M1, the fifth transistor M5, the sixth transistor M6, and the seventh transistor M7 are conducted, and the second transistor M2, the third transistor M3, the fourth transistor M4, and the eighth transistor M8 are cut off.

Specifically, the second sub-clock signal CLK1_2 input by the second sub-control end V1_2 to the gate of the second transistor M2 through the second node b is at a high level (VDD), and the second transistor M2 is a P-type transistor. Therefore, the second transistor M2 is cut off.

As shown in FIG. 11a and FIG. 11c, the first sub-clock signal CLK1_1 input by the first sub-control end V1_1 to the gate of the first transistor M1 and the gate of the seventh transistor M7 through the first node a is at a high level (VDD). The seventh transistor M7 is used to enhance a capability of the first sub-clock signal CLK1_1 to drive the gate of the first transistor M1. An operating process of the seventh transistor is: The seventh transistor M7 is conducted under control of a high level (VDD), so that the fourth node d is fixed at a low level (0 V). However, because the seventh transistor M7 and the eighth transistor M8 form a positive feedback and are alternately conducted, the eighth transistor M8 is cut off, so that the first node a is fixed at a high level (VDD), and the first transistor M1 electrically connected to the first node a is quickly conducted.

After the first transistor M1 is conducted, a power supply voltage input by the input end Vin may be received through the source. Because the input end Vin is electrically connected to the operating voltage end, a voltage value of the power supply voltage is VDD. The first transistor M1 inputs the power supply voltage VDD to the first capacitor C1, to charge the first capacitor C1.

It should be understood that, in phase 3 of the previous period, the third sub-clock signal CLK2_1 at the third sub-control end V2_1 is at a high level (VDD), and the first capacitor C1 is electrically connected between the third sub-control end V2_1 and the third node c. Therefore, in the current period, an initial voltage at the first capacitor C1 is VDD. In phase 1 of the current period, after the voltage VDD is input to the first capacitor C1 through the first transistor M1, the voltage at the first capacitor C1 is 2VDD.

According to the current formula of the N-type transistor, a conduction condition of the first transistor M1 serving as the N-type transistor is: A gate-source voltage difference Vgs_M1 of the first transistor M1 is above a threshold voltage Vthn of the N-type transistor (the threshold voltage Vthn is a positive number). If the third transistor M3 is conducted, the gate of the first transistor M1 is electrically connected to the source of the first transistor M1 through the third transistor M3, so that a voltage at the source of the first transistor M1 is the same as a voltage at the gate of the first transistor M1, that is, the gate-source voltage difference Vgs_M1 of the first transistor M1 is equal to 0. This does not meet the conduction condition of the first transistor M1, and is contrary to the fact that the first transistor M1 is conducted in phase 1 under the control of the first sub-clock signal CLK1_1. Therefore, in phase 1, the third transistor M3 is cut off.

Based on this, as shown in FIG. 11a and FIG. 11c, the third sub-clock signal CLK2_1 input by the third sub-control end V2_1 to the gate of the third transistor M3 through the third node c is at a low level (0 V), and the third transistor M3 is an N-type transistor. Therefore, the third transistor M3 is cut off.

When the third sub-control end V2_1 controls cut-off of the third transistor M3 through the third node c, the third sub-control end V2_1 further inputs the third sub-clock signal CLK2_1 to the fifth transistor M5 through the third node c, the third sub-clock signal CLK2_1 is at a low level (0 V), and the fifth transistor M5 is a P-type transistor. Therefore, the fifth transistor M5 is conducted. The second capacitor C2 discharges to the fifth transistor M5, and outputs a voltage 2VDD through the fifth transistor M5 and the output end Vout, to implement voltage boosting. The voltage 2VDD discharged by the second capacitor C2 to the fifth transistor M5 is a sum of a voltage VDD input by the input end Vin to the second capacitor C2 through the fourth transistor M4 in phase 2 of the previous period and a voltage VDD input to the second capacitor C2 through the second sub-control end V1_2 in phase 3 of the previous period. The operating processes of phase 2 and phase 3 of the previous period are the same as the operating processes of phase 2 and phase 3 of the current period. For details, refer to the following description of phase 2 and phase 3 of the current period.

The fourth sub-clock signal CLK2_2 input by the fourth sub-control end V2_2 to the gate of the fourth transistor M4 and the gate of the eighth transistor M8 through the fourth node d is at a low level (0 V). The eighth transistor M8 is used to enhance a capability of the fourth sub-clock signal CLK2_2 to drive the gate of the first transistor M1. An operating process of the eighth transistor is: The eighth transistor M8 is cut off under the control of a low level (0 V), and the seventh transistor M7 is conducted, so that the fourth node d is fixed at a low level (0 V), and the fourth transistor M4 electrically connected to the fourth node d is quickly cut off.

The second sub-clock signal CLK1_2 input by the second sub-control end V1_2 to the gate of the sixth transistor M6 through the second node b is at a high level (VDD), and the sixth transistor M6 is an N-type transistor. Therefore, the sixth transistor M6 is cut off. Because the fourth transistor M4 is cut off in phase 1, conduction of the sixth transistor M6 does not affect the fourth transistor M4.

As shown in FIG. 11a and FIG. 11c, in phase 2, the second transistor M2, the third transistor M3, the fourth transistor M4, and the eighth transistor M8 are conducted, and the first transistor M1, the fifth transistor M5, the sixth transistor M6, and the seventh transistor M7 are cut off.

Specifically, the first sub-clock signal CLK1_1 input by the first sub-control end V1_1 to the gate of the first transistor M1 and the gate of the seventh transistor M7 is at a low level (0 V). The seventh transistor M7 is used to enhance a capability of the first sub-clock signal CLK1_1 to drive the gate of the first transistor M1. An operating process of the seventh transistor is: The seventh transistor M7 is cut off under the control of a low level (0 V), and the eighth transistor M8 is conducted, so that the first node a is fixed at a low level (0 V), and the first transistor M1 electrically connected to the first node a is quickly cut off.

The third sub-clock signal CLK2_1 input by the third sub-control end V2_1 to the gate of the third transistor M3 is at a high level (VDD), and the third transistor M3 is an N-type transistor. Therefore, the third transistor M3 is conducted. Because the first transistor M1 is cut off in phase 2, conduction of the third transistor M3 does not affect the first transistor M1.

The second sub-clock signal CLK1_2 input by the second sub-control end V1_2 to the gate of the second transistor M2 is at a low level (0 V), and the second transistor M2 is a P-type transistor. Therefore, the second transistor M2 is conducted. The first capacitor C1 discharges to the second transistor M2, and outputs a voltage 2VDD through the second transistor M2 and the output end Vout, to implement voltage boosting.

The fourth sub-clock signal CLK2_2 input by the fourth sub-control end V2_2 to the gate of the fourth transistor M4 and the gate of the eighth transistor M8 through the fourth node d is at a high level (VDD). The eighth transistor M8 is used to enhance a capability of the fourth sub-clock signal CLK2_2 to drive the gate of the fourth transistor M4. An operating process of the eighth transistor is: The eighth transistor M8 is conducted under the control of a high level (VDD), so that the first node a is fixed at a low level (-VDD). However, because the seventh transistor M7 and the eighth transistor M8 form a positive feedback and are alternately conducted, the seventh transistor M7 is cut off, so that the fourth node d can be fixed at a high level (VDD), and the fourth transistor M4 electrically connected to the fourth node d can be quickly conducted.

After the fourth transistor M4 is conducted, a power supply voltage input by the input end Vin may be received through the source. Because the input end Vin is electrically connected to the operating voltage end, a voltage value of the power supply voltage is VDD. The fourth transistor M4 inputs the power supply voltage VDD to the second capacitor C2, to charge the second capacitor C2.

It should be understood that, in phase 3 of the previous period, the second sub-clock signal CLK1_2 at the second sub-control end V1_2 is at a high level (VDD), and the second capacitor C2 is electrically connected between the second sub-control end V1_2 and the second node b. Therefore, in the current period, an initial voltage at the second capacitor C2 is -VDD. In phase 2 of the current period, after a voltage 0 V is input to the second capacitor C2, the voltage at the second capacitor C2 is still -VDD.

According to the current formula of the N-type transistor, a conduction condition of the fourth transistor M4 serving as the N-type transistor is: A gate-source voltage difference Vgs_M4 of the fourth transistor M4 is above a threshold voltage Vthn of the N-type transistor (the threshold voltage Vthn is a positive number). If the sixth transistor M6 is conducted, the gate of the fourth transistor M4 is electrically connected to the source of the fourth transistor M4 through the sixth transistor M6, so that a voltage at the source of the fourth transistor M4 is the same as a voltage at the gate of the fourth transistor M4, that is, the gate-source voltage difference Vgs_M4 of the fourth transistor M4 is equal to 0. This does not meet the conduction condition of the fourth transistor M4 and is contrary to the fact that the fourth transistor M4 is conducted under control of the fourth sub-clock signal CLK2_2 in phase 1. Therefore, in phase 2, the sixth transistor M6 is cut off.

Based on this, as shown in FIG. 11a and FIG. 11c, the second sub-clock signal CLK1_2 input by the second sub-control end V1_2 to the gate of the sixth transistor M6 through the second node b is at a low level (0 V), and the sixth transistor M6 is an N-type transistor. Therefore, the sixth transistor M6 is cut off.

As shown in FIG. 11a and FIG. 11c, in phase 3, the third sub-control end V2_1 is still at a high level (VDD), and the third sub-control end V2_1 may continue to charge the first capacitor C1 The second sub-control end V1_2 is still at a high level (VDD), and the second sub-control end V1_2 may continue to charge the second capacitor C2.

In addition, based on a typical cross-coupled positive charge pump circuit structure, the first transistor M1, the second transistor M2, the fourth transistor M4, and the fifth transistor M5 form a main part of the latched charge pump. The first sub-clock signal CLK1_1, the second sub-clock signal CLK1_2, the third sub-clock signal CLK2_1, and the fourth sub-clock signal CLK2_2 are adjusted as four-phase anti-aliasing clock signals, and a dead time operation is performed on each phase, so that the first boost circuit 11 and the second boost circuit 12 alternately operate in phase 1 and phase 2. This reduces electric leakage when the positive charge pump circuit operates.

An example in which the charge pump circuit is a positive charge pump circuit is still used. As shown in FIG. 11b, when the positive charge pump is in a non-operating state, a voltage at the first sub-control end V1_1 is a first sub-fixed voltage, a voltage at the second sub-control end V1_2 is a second sub-fixed voltage, a voltage at the third sub-control end V2_1 is a third sub-fixed voltage, and a voltage at the fourth sub-control end V2_2 is a fourth sub-fixed voltage. The first sub-fixed voltage, the second sub-fixed voltage, the third sub-fixed voltage, and the fourth sub-fixed voltage may be the same, or may be different. Optionally, the first sub-fixed voltage, the second sub-fixed voltage, the third sub-fixed voltage, and the fourth sub-fixed voltage are the same.

For example, the first sub-control end V1_1, the second sub-control end V1_2, the third sub-control end V2_1, and the fourth sub-control end V2_2 each are electrically connected to the ground end, and the first sub-fixed voltage, the second sub-fixed voltage, the third sub-fixed voltage, and the fourth sub-fixed voltage each are 0 V; or the first sub-control end V1_1, the second sub-control end V1_2, the third sub-control end V2_1, and the fourth sub-control end V2_2 each are electrically connected to the operating voltage end, and the first sub-fixed voltage, the second sub-fixed voltage, the third sub-fixed voltage, and the fourth sub-fixed voltage each are a VDD.

For ease of description, the following uses an example in which the first sub-control end V1_1, the second sub-control end V1_2, the third sub-control end V2_1, and the fourth sub-control end V2_2 each are electrically connected to the ground end, and voltages of the first sub-fixed voltage, the second sub-fixed voltage, the third sub-fixed voltage, and the fourth sub-fixed voltage each are 0 V for description.

As the name implies, the first sub-fixed voltage, the second sub-fixed voltage, the third sub-fixed voltage, and the fourth sub-fixed voltage each are a fixed voltage value. Different from the clock signal, the fixed voltage has no signal fluctuation (in other words, there is no power down). Therefore, when the positive charge pump is in the non-operating state, voltages at the second electrode of the first capacitor C1, the fourth electrode of the second capacitor C2, the sixth electrode of the third capacitor C3, and the eighth electrode of the fourth capacitor C4 each are 0 V, and the first electrode of the first capacitor C1, the third electrode of the second capacitor C2, the fifth electrode of the third capacitor C3, and the eighth electrode of the fourth capacitor C4 each are in a floating state.

Further, the first electrode of the first capacitor C1 is electrically connected to the gate of the third transistor M3 and the gate of the fifth transistor M5 through the third node c, the third electrode of the second capacitor C2 is electrically connected to the gate of the second transistor M2 and the gate of the sixth transistor M6 through the second node b, the fifth electrode of the third capacitor C3 is electrically connected to the gate of the first transistor M1 and the gate of the seventh transistor M7 through the first node a, and the seventh electrode of the fourth capacitor C4 is electrically connected to the gate of the fourth transistor M4 and the gate of the eighth transistor M8 through the fourth node d. Therefore, when the first electrode of the first capacitor C1, the third electrode of the second capacitor C2, the fifth electrode of the third capacitor C3, and the eighth electrode of the fourth capacitor C4 each are in a floating state, conduction statuses of the first transistor M1 to the eighth transistor M8 are uncertain.

It is assumed that the power supply voltage is boosted through the first boost circuit 11, the first transistor M1 and the second transistor M2 are conducted, and the third transistor M3 and the fifth transistor M5 are cut off. The first transistor M1 operates in a saturation region, the second transistor M2 operates in a linear region, and the third transistor M3 and the fifth transistor M5 operate in a cut-off region.

If the first transistor M1 is conducted, the source-gate voltage difference Vgs_M1 of the first transistor M1 needs to satisfy Formula 7:

$$V_{gs\_M1} = \text{Va--VDD} > V_{thn} \quad \text{(Formula 7)}.$$

VDD indicates that a voltage that is input by the input end Vin and that is received by the source of the first transistor M1 is VDD, and Va indicates a voltage at the first node a.

Further, if the first transistor M1 operates in the saturation region, a source-drain voltage difference Vsd_M1 of the first transistor M1 needs to satisfy Formula 8:

$$V_{sd\_M1} = \text{VDD--Vc} > V_{gs\_M1} - V_{thn} = \text{Va--VDD--} V_{thn} \quad \text{(Formula 8)}.$$

Vc indicates a voltage at the third node c.

If the second transistor M2 operates in the linear region, the second transistor M2 needs to satisfy Formula 9:

$$\text{V2--} V_o > V_{thp} \quad \text{(Formula 9)}.$$

The drain of the second transistor M2 is electrically connected to the output end Vout, and Vo indicates a voltage at the output end Vo.

If the third transistor M3 operates in the cut-off region, a source-gate voltage difference Vgs_M3 of the third transistor M3 needs to satisfy Formula 10:

$$V_{gs\_M3} = Vc - \text{VDD} < V_{thn} \quad \text{(Formula 10)}.$$

If the fifth transistor M5 operates in the cut-off region, the fifth transistor M5 needs to satisfy Formula 11:

$$Vo - \text{Vc} < V_{thp} \quad \text{(Formula 11)}.$$

Further, the following is obtained through derivation according to Formula 10 and Formula 11:

$$Vo - V_{thp} < Vc < V_{thp} + VDD \quad \text{(Formula 12)}.$$

$Vo\text{-}VDD < V_{thp} + V_{thn}$ may be obtained according to Formula 12.

However, in the positive charge pump circuit, the voltage Vo output by the first boost circuit 11 is 2DD. Therefore, $Vo\text{-}VDD < V_{thp} + V_{thn}$ may be represented as $VDD < V_{thp} + V_{thn}$.

Further, the positive charge pump circuit requires a power supply of 2 V to 3.3 V for the CIS. For example, the positive charge pump circuit requires a power supply of VDD=2.8 V for the CIS, or the positive charge pump circuit requires a power supply of VDD=3.3 V for the CIS. For example, the positive charge pump circuit requires a power supply of VDD=2.8 V for the CIS, and $V_{thp} + V_{thn} > VDD$=2.8 V.

However, for a current standard CMOS process for preparing the CIS, regardless of whether the CMOS is an N-type transistor or a P-type transistor, neither a threshold voltage Vthn of the N-type transistor nor a threshold voltage Vthp of the P-type transistor exceeds 1 V. Further, a sum of the threshold voltage Vthn of the N-type transistor and the threshold voltage Vthp of the P-type transistor cannot exceed 2 V. Therefore, $V_{thp} + V_{thn} > VDD$=2 V is not established.

In addition, it is reversely proved that it is not established when the positive charge pump circuit is in the non-operating state, the first transistor M1 is conducted and the third transistor M3 is cut off. It can be learned from the foregoing description that, to cut off the first transistor M1, the third transistor M3 may be conducted, that is, when the third transistor M3 is conducted, the source and the gate of the first transistor M1 are conducted, and the gate-source voltage difference Vgs_M1 of the first transistor M1 is 0, so that the first transistor M1 is cut off. In other words, the cut-off signal is input to the gate of the first transistor M1 through the conducted third transistor M3, so that the first transistor M1 is cut off.

The first transistor M1 is used as a part of the first boost circuit 11, and when the first transistor M1 is cut off, the first boost circuit 11 is also disconnected. In this way, the backflow current Iout cannot be input from the positive charge pump circuit in the operating state to the positive charge pump circuit in the non-operating state through the first boost circuit 11.

Similarly, it is assumed that the power supply voltage is boosted through the second boost circuit 12. According to the foregoing formula, a conclusion that the fourth transistor M4 is conducted and the sixth transistor M6 is cut off being not established, and a conclusion that the fifth transistor M5 is cut off by using the conducted sixth transistor M6 may also be obtained through derivation. In this way, the second boost circuit 12 is cut off, and the backflow current Iout cannot be input from the positive charge pump circuit in the operating state to the positive charge pump circuit in the non-operating state through the second boost circuit 12. Details are not described herein again.

In some possible implementations, in this embodiment of this application, voltage switching at the first sub-control end V1_1, the second sub-control end V1_2, the third sub-control end V2_1, and the fourth sub-control end V2_2 may be implemented by using a switch or through a logic circuit. For details, refer to an implementation of the negative charge pump circuit in the foregoing embodiment.

The foregoing describes embodiments of this application with reference to the accompanying drawings. However, this application is not limited to the foregoing specific implementations. The foregoing specific implementations are merely examples, and are not limitative. Inspired by this application, a person of ordinary skill in the art may further make many modifications without departing from the purposes of this application and the protection scope of the claims, and all the modifications shall fall within the protection scope of this application.

## Claims

1. A charge pump circuit, comprising a first auxiliary circuit, a second auxiliary circuit, an input end, an output end, and a first boost circuit and a second boost circuit connected in parallel, wherein the first boost circuit and the second boost circuit are electrically connected between the input end and the output end; and

   when the charge pump circuit is in an operating state, the first boost circuit and the second boost circuit are separately configured to: receive a power supply voltage input by the input end, and boost the power supply voltage; or
   when the charge pump circuit is in a non-operating state, the first boost circuit is further configured to be disconnected under control of a cut-off signal input by the first auxiliary circuit; and the second boost circuit is further configured to be disconnected under control of a cut-off signal input by the second auxiliary circuit.

2. The charge pump circuit according to claim 1, wherein the charge pump circuit further comprises a first control end and a second control end;

the first boost circuit comprises a first transistor, wherein a gate of the first transistor is electrically connected to the first control end, a first electrode is electrically connected to the input end, and a second electrode is electrically connected to the output end;

the first auxiliary circuit comprises a third transistor, wherein a gate of the third transistor is electrically connected to the second control end, a first electrode is electrically connected to the input end, and a second electrode is electrically connected to the gate of the first transistor; and

when the charge pump circuit is in the non-operating state, the first transistor is cut off under control of the third transistor.

3. The charge pump circuit according to claim 2, wherein the first boost circuit further comprises a second transistor and a first capacitor;

a gate of the second transistor is electrically connected to the first control end, a first electrode is electrically connected to the second electrode of the first transistor, and a second electrode is electrically connected to the output end; and

the first capacitor comprises a first electrode and a second electrode, the first electrode is electrically connected to the second electrode of the first transistor and the first electrode of the second transistor, and the second electrode is electrically connected to the second control end.

4. The charge pump circuit according to claim 3, wherein the second boost circuit comprises a fourth transistor; and a gate of the fourth transistor is electrically connected to the second control end, a first electrode is electrically connected to the input end, and a second electrode is electrically connected to the output end;

the second auxiliary circuit comprises a sixth transistor, wherein a gate of the sixth transistor is electrically connected to the first control end, a first electrode is electrically connected to the input end, and a second electrode is electrically connected to the gate of the fourth transistor; and

when the charge pump circuit is in the non-operating state, the fourth transistor is cut off under control of the sixth transistor.

5. The charge pump circuit according to claim 4, wherein the second boost circuit further comprises a fifth transistor and a second capacitor;

a gate of the fifth transistor is electrically connected to the second control end, a first electrode is electrically connected to the second electrode of the fourth transistor, and a second electrode is electrically connected to the output end; and

the second capacitor comprises a third electrode and a fourth electrode, the third electrode is electrically connected to the second electrode of the fourth transistor and the first electrode of the fifth transistor, and the fourth electrode is electrically connected to the first control end.

6. The charge pump circuit according to any one of claims 2 to 5, wherein

when the charge pump circuit is in the operating state, a voltage at the first control end is a first clock signal, and a voltage at the second control end is a second clock signal; or

when the charge pump circuit is in the non-operating state, a voltage at the first control end is a first fixed voltage, and a voltage at the second control end is a second fixed voltage.

7. The charge pump circuit according to claim 6, wherein the first fixed voltage and the second fixed voltage are the same.

8. The charge pump circuit according to claim 6 or 7, wherein if the charge pump circuit is a negative charge pump, the input end is electrically connected to a ground end, the first transistor, the third transistor, the fourth transistor, and the sixth transistor each are a P-type transistor, and the second transistor and the fifth transistor each are an N-type transistor; or

if the charge pump circuit is a positive charge pump circuit, the input end is electrically connected to an operating voltage end, the first transistor, the third transistor, the fourth transistor, and the sixth transistor each are an N-type transistor, and the second transistor and the fifth transistor each are a P-type transistor.

9. The charge pump circuit according to claim 5, wherein the charge pump circuit is a cross-coupled charge pump circuit;

the first control end comprises a first sub-control end and a second sub-control end, the second control end comprises a third sub-control end and a fourth sub-control end, the charge pump circuit further comprises a seventh transistor, an eighth transistor, a third capacitor, and a fourth capacitor, the third capacitor comprises a fifth electrode and a sixth electrode, and the fourth capacitor comprises a seventh electrode and an eighth electrode;

the first sub-control end is electrically connected to the gate of the first transistor and a gate of the seventh transistor, the second sub-control end is electrically connected to the gate of the second transistor and the gate of the sixth transistor, the third sub-control end is electrically connected to the gate of the third transistor and the gate of the fifth transistor, and the fourth sub-control end is electrically connected to the gate of the fourth transistor and a gate of the eighth transistor;

a first electrode of the seventh transistor is electrically connected to the input end, a second electrode is electrically connected to the gate of the fourth transistor and the gate of the eighth transistor, a first electrode of the eighth transistor is electrically connected to the input end, and a second electrode is electrically connected to the gate of the first transistor and the gate of the seventh transistor; and

the fifth electrode is electrically connected to the gate of the first transistor and the gate of the seventh transistor, the sixth electrode is electrically connected to the first sub-control end, the seventh electrode is electrically connected to the gate of the fourth transistor and the gate of the eighth transistor, and the eighth electrode is electrically connected to the fourth sub-control end.

10. The charge pump circuit according to claim 9, wherein

when the charge pump circuit is in the operating state, a voltage at the first sub-control end is a first sub-clock signal, a voltage at the second sub-control end is a second sub-clock signal, a voltage at the third sub-control end is a third sub-clock signal, and a voltage at the fourth sub-control end is a fourth sub-clock signal; or

when the charge pump circuit is in the non-operating state, a voltage at the first sub-control end is a first sub-fixed voltage, a voltage at the second sub-control end is a second sub-fixed voltage, a voltage at the third sub-control end is a third sub-fixed voltage, and a voltage at the fourth sub-control end is a fourth sub-fixed voltage.

11. The charge pump circuit according to claim 10, wherein the first sub-fixed voltage, the second sub-fixed voltage, the third sub-fixed voltage, and the fourth sub-fixed voltage are the same.

12. The charge pump circuit according to any one of claims 9 to 11, wherein if the charge pump circuit is a negative charge pump circuit, and the seventh transistor and the eighth transistor each are a P-type transistor; or

if the charge pump circuit is a positive charge pump circuit, and the seventh transistor and the eighth transistor each are an N-type transistor.

13. A power management circuit, comprising a plurality of power management units, wherein the power management unit comprises a plurality of charge pump circuits according to any one of claims 1 to 12; and

in a same power management unit, a plurality of charge pump circuits each are a positive charge pump circuit, and the plurality of positive charge pump circuits are connected in parallel; or in a same power management unit, a plurality of charge pump circuits each are a negative charge pump circuit, and the plurality of negative charge pump circuits are connected in parallel.

14. A terminal, comprising a circuit board and the power management circuit according to claim 13, wherein the power management circuit is disposed on the circuit board.

Circuit board

Internal memory

Processor

Camera

Display

Power management circuit

Battery

Charging management circuit

Charging circuit

FIG. 1

FIG. 2a

FIG. 2b

PCP

Non-operating state

Iout

PCP

Operating state

Pixel

FIG. 2c

FIG. 3

FIG. 4a

FIG. 4b

FIG. 5a

FIG. 5b

FIG. 6

FIG. 7

FIG. 8a

FIG. 8b

FIG. 8c

FIG. 9a

FIG. 9b

FIG. 10

FIG. 11a

FIG. 11b

FIG. 11c

Europäisches
Patentamt

European
Patent Office

Office européen
des brevets

# EUROPEAN SEARCH REPORT

Application Number

EP 24 16 4072

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/258810 A1 (LIN CHING-WEI [TW]) 24 November 2005 (2005-11-24) * paragraphs [0041], [0044], [0045], [0100], [0103]; figures 3-10 * | 1-14 | INV. H02M3/07 G11C16/30 |
| A | US 2002/001207 A1 (KISHIMOTO JIRO [JP] ET AL) 3 January 2002 (2002-01-03) * paragraph [0056]; figures 1-7 * | 1-14 | |
| A | CN 115 800 732 A (BEIJING PANXIN MICROELECTRONICS TECH CO LTD) 14 March 2023 (2023-03-14) * abstract; figures 2,8 * | 1-14 | |
| A | US 2009/219077 A1 (PIETRI STEFANO [US] ET AL) 3 September 2009 (2009-09-03) * paragraphs [0017], [0018], [0020]; figure 4 * | 1-14 | |

TECHNICAL FIELDS
SEARCHED      (IPC)

H02M
G11C

The present search report has been drawn up for all claims

| Place of search | Date of completion of the search | Examiner |
|---|---|---|
| The Hague | 14 August 2024 | Kanelis, Konstantin |

EPO FORM 1503 03.82 (P04C01)

## ANNEX TO THE EUROPEAN SEARCH REPORT
## ON EUROPEAN PATENT APPLICATION NO.

EP 24 16 4072

This annex lists the patent family members relating to the patent documents cited in the above-mentioned European search report.
The members are as contained in the European Patent Office EDP file on
The European Patent Office is in no way liable for these particulars which are merely given for the purpose of information.

14-08-2024

| Patent document cited in search report | | Publication date | Patent family member(s) | | Publication date |
|---|---|---|---|---|---|
| US 2005258810 | A1 | 24-11-2005 | CN | 1700571 A | 23-11-2005 |
| | | | JP | 4858894 B2 | 18-01-2012 |
| | | | JP | 2005333790 A | 02-12-2005 |
| | | | JP | 2008278752 A | 13-11-2008 |
| | | | TW | I250495 B | 01-03-2006 |
| | | | US | 2005258810 A1 | 24-11-2005 |
| US 2002001207 | A1 | 03-01-2002 | JP | 2002026254 A | 25-01-2002 |
| | | | KR | 20020004829 A | 16-01-2002 |
| | | | TW | 521500 B | 21-02-2003 |
| | | | US | 2002001207 A1 | 03-01-2002 |
| CN 115800732 | A | 14-03-2023 | NONE | | |
| US 2009219077 | A1 | 03-09-2009 | NONE | | |

EPO FORM P0459

For more details about this annex : see Official Journal of the European Patent Office, No. 12/82